(19) Europäisches Patentamt
European Patent Office
Office européen des brevets

(11) EP 2 486 661 B1

(12) # FASCICULE DE BREVET EUROPEEN

(45) Date de publication et mention de la délivrance du brevet:
**13.06.2018 Bulletin 2018/24**

(21) Numéro de dépôt: **10767963.1**

(22) Date de dépôt: **30.09.2010**

(51) Int Cl.:
***H03M 13/11*** *(2006.01)* ***H04L 1/00*** *(2006.01)*

(86) Numéro de dépôt international:
**PCT/EP2010/064533**

(87) Numéro de publication internationale:
**WO 2011/042352 (14.04.2011 Gazette 2011/15)**

(54) **PROCÉDÉ DE DÉCODAGE DE CODES NON BINAIRES**

VERFAHREN ZUR DECODIERUNG VON NICHTBINÄREN CODES

METHOD FOR DECODING NON-BINARY CODES

(84) Etats contractants désignés:
**AL AT BE BG CH CY CZ DE DK EE ES FI FR GB GR HR HU IE IS IT LI LT LU LV MC MK MT NL NO PL PT RO SE SI SK SM TR**

(30) Priorité: **09.10.2009 FR 0957062**

(43) Date de publication de la demande:
**15.08.2012 Bulletin 2012/33**

(73) Titulaire: **Commissariat à l'Énergie Atomique et aux Énergies Alternatives**
**75015 Paris (FR)**

(72) Inventeur: **SAVIN, Valentin**
**38000 Grenoble (FR)**

(74) Mandataire: **Ilgart, Jean-Christophe**
**BREVALEX**
**95, rue d'Amsterdam**
**75378 Paris Cedex 8 (FR)**

(56) Documents cités:

**GB-A- 2 455 274**

- **POULLIAT C ET AL: "Design of regular (2,dc)-LDPC codes over GF(q) using their binary images", IEEE TRANSACTIONS ON COMMUNICATIONS, IEEE SERVICE CENTER, PISCATAWAY, NJ, US LNKD-DOI:10.1109/TCOMM.2008.060527, vol. 56, no. 10, 1 octobre 2008 (2008-10-01), pages 1626-1635, XP011236194, ISSN: 0090-6778**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

EP 2 486 661 B1

## Description

### DOMAINE TECHNIQUE

La présente invention concerne le décodage de codes correcteurs d'erreurs dans le domaine des télécommunications ou de l'enregistrement de données. Plus précisément, l'invention est relative à une méthode de décodage à passage de messages de codes non binaires, en particulier de codes LDPC (*Low Density Parity Check*) non binaires.

### ÉTAT DE LA TECHNIQUE ANTÉRIEURE

Les codes LDPC ont été introduits par R. Gallager dans son article intitulé « Low density parity check codes » publié dans IEEE Trans. Inform. Theory, vol. IT-8, pages 21-28, 1962, et leurs intéressantes propriétés n'ont été redécouvertes que récemment, lorsque la puissance du décodage itératif a été mise en évidence dans les turbocodes. On trouvera une description du décodage itératif des turbocodes dans l'article fondateur de C. Berrou et al. intitulé « Near optimum error correcting coding and decoding : turbocodes » paru dans IEEE Trans. Inform. Theory, vol. 44, N° 10, pages 1261-1271, 1996.

Les codes LDPC tout comme les turbocodes sont susceptibles d'une représentation par graphe bipartite.

On appelle graphe bipartite un graphe non orienté dont l'ensemble des noeuds est constitué de deux sous-ensembles disjoints tels que deux noeuds quelconques d'un même sous-ensemble ne sont pas reliés entre eux par une arête du graphe.

De manière générale, certains codes correcteurs d'erreurs sont susceptibles d'une représentation par graphe bipartite. Ce graphe est partitionné en un premier sous-ensemble de noeuds associés aux symboles constituant un mot de code, dits noeuds de variable, et un second sous-ensemble de noeuds associés aux contraintes du code, encore appelés noeuds de contrôle. Un graphe bipartite associé à un groupe de contraintes est encore appelé graphe de Tanner. Lorsque les symboles du mot de code sont binaires, les contraintes du code sont appelées contrôles de parité. Ainsi, dans la suite, par souci de clarté, nous utiliserons le terme spécifique de contrôle de parité dans le cas où il s'agira d'un code binaire et le terme plus général de contrainte dans le cas où il s'agira d'un code non-binaire.

Les symboles du mot de code sont en général des éléments du corps de Galois $\mathbf{F}_2 = \{0,1\}$, autrement dit des bits, mais ils peuvent plus généralement être des éléments d'un alphabet de taille $q \geq 2$, par exemple d'un corps $\mathbf{F}_{2_p}$ de caractéristique 2 quelconque, c'est-à-dire d'un alphabet $2^p$-aire (donc $q=2^p$).

Les codes susceptibles de représentation par graphe bipartite peuvent être décodés au moyen d'un décodage itératif à passage de messages, dit aussi de type MP (*Message Passing*) ou BP (*Belief Propagation*). On trouvera une description générique de cette méthode de décodage dans la thèse de N. Wiberg intitulée « Codes and decoding on général graphs », 1996. Le décodage itératif de type MP est en fait une généralisation d'algorithmes bien connus dans le domaine du décodage à savoir l'algorithme « forward-backward » utilisé pour les turbocodes et l'algorithme de Gallager pour les codes LDPC.

Le décodage par passage de messages d'un code non binaire diffère de celui d'un code binaire.

En effet pour les codes binaires tels que les codes LDPC binaires, chaque noeud de variable représente un bit codé. Lorsqu'il y a incertitude sur la valeur d'un bit, celle-ci s'exprime en termes de probabilité des valeurs 0 ou 1, ou plus fréquemment comme un rapport de vraisemblance logarithmique, dit LLR (*Log Likelihood Ratio*), défini comme le logarithme du rapport de ces probabilités. Les messages échangés entre les noeuds du graphe bipartite sont alors libellés, selon le cas, en termes de probabilité ou de LLR.

Pour les codes non binaires, chaque noeud de variable représente un symbole codé, c'est-à-dire un élément de l'alphabet du code. Lorsqu'il y a incertitude sur la valeur d'un symbole, cette incertitude peut être représentée par un vecteur de $q$-*1* probabilités, où $q$ est la taille de l'alphabet ($q$-1 probabilités suffisent puisque la somme des $q$ probabilités vaut 1), ou $q$-1 valeurs de LLR. Les messages échangés entre les noeuds du graphe bipartite sont également exprimés, selon le cas, sous forme de vecteurs de $q$-1 valeurs de probabilité ou de $q$-1 valeurs de LLR.

On a représenté en Fig. 1, un exemple de graphe bipartite pour un code non binaire, plus précisément un code LDPC défini sur $\mathbf{F}_8$ ayant pour matrice de parité une matrice de taille $M \times N$ où $N$=6 est le nombre de variables et $M$=3 est le nombre de contraintes :

$$\mathbf{H} = \begin{pmatrix} 1 & 3 & 4 & 6 & 0 & 0 \\ 0 & 2 & 0 & 7 & 1 & 5 \\ 5 & 0 & 1 & 0 & 2 & 4 \end{pmatrix} \qquad (1)$$

On remarquera que les coefficients de la matrice sont des éléments de $\mathbf{F}_8$. On a fait figurer dans la partie gauche du graphe les noeuds de variable $X_1,...,X_N$ et dans la partie droite les noeuds de contrainte $Y_1,...,Y_M$. Dans le cas présent :

$$\begin{aligned} Y_1: &\quad X_1+3X_2+4X_3+6X_4=0 \\ Y_2: &\quad X_2+7X_4+X_5+5X_6=0 \\ Y_3: &\quad 5X_1+X_3+2X_5+4X_6=0 \end{aligned} \qquad (2)$$

Les messages des variables $X_1,...,X_6$ et des contraintes $Y_1,...,Y_3$ peuvent être chacun exprimé comme un vecteur de probabilités de dimension 7.

La matrice d'incidence du graphe correspond à la matrice de parité du code, en d'autres termes les poids affectés aux arêtes du graphe représentent les coefficients de la matrice **H**. Par convention lorsque le poids est nul, l'arête correspondante est omise dans le graphe.

Si les codes LDPC non binaires présentent de meilleures capacités de correction que les codes LDPC binaires, ils sont en revanche sensiblement plus difficiles à décoder. En effet la complexité de l'algorithme de décodage est en général proportionnelle à $q^2$, c'est-à-dire au carré de la taille de l'alphabet. Une méthode de décodage des codes LDPC non binaires a été décrite par exemple dans l'article de V. Savin intitulé « Min-Max decoding for non binary LDPC codes », publié dans IEEE Int. Symp. on Information Theory (ISIT), Toronto, Canada, 2008. Une autre méthode est décrite dans GB2455274A, publié le 10-06-2009.

L'homme du métier pourrait penser qu'une manière naturelle de décoder des codes non binaires serait d'utiliser une représentation binaire équivalente de la matrice de parité. Toutefois, comme nous allons le voir, cette représentation binaire « naturelle » conduirait à des performances de décodage médiocres et un taux d'erreurs élevé.

On sait que les codes LDPC tant binaires que non binaires ont pour propriété de présenter une faible densité de coefficients non nuls dans la matrice de parité. Cette propriété se traduit par une faible nombre de cycles courts dans le graphe bipartite. Ces cycles ont tendance à engendrer une auto-confirmation des variables et des contrôles dans le processus de décodage itératif. On entend par là qu'une valeur erronée d'un noeud peut se voir confirmée par le simple fait que les messages que lui transmettent ses voisins dépendent eux-mêmes des messages que ce noeud leur transmet. Pour combattre ce phénomène d'auto-confirmation, le décodage doit respecter le principe dit d'information extrinsèque : un message transmis par un noeud expéditeur à un noeud destinataire est calculé à partir de tous les messages reçus par le noeud expéditeur à l'exception de celui en provenance du noeud destinataire. Toutefois, le respect du principe d'information extrinsèque n'exclut pas des auto-confirmations à des ordres plus élevés, dus aux cycles présents dans le graphe bipartite, ces auto-confirmations étant d'autant plus fréquentes que les cycles sont courts.

Le principe de l'information extrinsèque a été schématiquement illustré en Fig. 2. On a représenté ici une portion d'un graphe bipartite dans lequel $Y_1,Y_2,Y_3$ sont des noeuds de contrôle et $X_1,...,X_4$ sont des noeuds de variable. Le message du noeud de contrainte $Y_1$ à destination du noeud de variable $X_1$ est calculé à partir des messages reçus par $Y_1$ des noeuds de variable $X_2,X_3,X_4$, sans tenir compte du message reçu de $X_1$. Réciproquement, le message du noeud de contrôle $X_1$ à destination du noeud de contrôle $Y_1$ est calculé à partir des messages reçus par $X_1$ des noeuds de contrôle $Y_2$ et $Y_3$ sans tenir compte du message reçu de $Y_1$.

La Fig. 3 illustre le phénomène d'auto-confirmation dû à la présence d'un cycle dans un graphe bipartite. On a représenté comme précédemment une portion de graphe, les noeuds de variable par des cercles et les noeuds de contrôle par des carrés. Le cycle dans le graphe a été représenté en traits gras. En parcourant ce cycle on se rend compte que le message $m_6$ reçu par le noeud de variable $X_5$ dépend indirectement du message $m_1$ transmis par ce même noeud quelques itérations de décodage auparavant, via les messages successifs $m_2$ à $m_5$.

On considère ci-après un alphabet $A$ à $q$ éléments. Les éléments de $A$ seront appelés des « symboles ». Nous supposerons dans un souci de simplification mais sans perte de généralité que $q=2^p$ est une puissance de 2. Il existe alors une bijection de $A$ sur $\mathbf{F}_2^p$ :

$$\omega : A \xrightarrow{\sim} \mathbf{F}_2^p \qquad (3)$$

où $\mathbf{F}_2 = \{0,1\}$ est le corps à deux éléments. Un vecteur binaire $\mathbf{x} = (x_0, x_1, .., x_{p-1}) \in \mathbf{F}_2^p$ est appelé « image binaire » d'un symbole $X \in A$ si $\omega(X) = \mathbf{x}$.

La bijection $\omega$ munit A d'une structure de $\mathbf{F}_2$-espace vectoriel. On note $\mathbf{L} = \mathcal{L}_{\mathbf{F}_2}(A)$ l'algèbre des $\mathbf{F}_2$-endo-

morphismes de $A$, c'est-à-dire des endomorphismes de $A$ munie de sa structure de $\mathbf{F}_2$-espace vectoriel. L'évaluation des éléments de **L** sur les symboles de $A$ définit une action de **L** sur $A$, qui sera notée multiplicativement :

$$\mathbf{L}\times A \to A : (h, X) \mapsto hX \qquad (4)$$

Soit $\mathbf{H} \in \mathbf{M}_{M,N}(\mathbf{L})$, c'est-à-dire soit **H** une matrice de taille $M \times N$ dont les éléments sont de **L**.

On définit un code non-binaire $C \subset A^N$ par:

$$\begin{aligned} C &= \mathrm{Ker}(\mathbf{H}) \subset A^N \\ &= \left\{ (X_1, \ldots, X_N) \in A^N \mid \sum_{n=1}^{N} h_{m,n} X_n = 0, \forall m = 1,.., M \right\} \end{aligned} \qquad (5)$$

On appellera **H** la matrice de contrainte du code $C$. A l'aide de la bijection ω, on peut faire correspondre à chaque séquence de symboles $(X_1,...,X_N) \in A^N$ une séquence binaire $(x_{1,0}, x_{1,1}, \ldots, x_{1,p-1}, \ldots\ldots, x_{N,0}, x_{N,1}, \ldots, x_{N,p-1}) \in \mathbf{F}_2^{Np}$ en remplaçant chaque symbole $X_n$ par son image binaire. Cette séquence binaire (de longueur $Np$) sera dénommée l'« *image binaire* » de la séquence $(X_1,...,X_N) \in A^N$. Les images binaires de tous les mots de code $(X_1,...,X_N), \in C \subset A^N$ forment un code binaire $C_{\mathrm{bin}} \subset F_2^{Np}$ dénommé « *image binaire de C* ».

L'isomorphisme ω entre $A$ et $\mathbf{F}_2^p$ induit un isomorphisme entre $\mathcal{L}_{\mathbf{F}_2}(A)$ et $\mathcal{L}_{\mathbf{F}_2}(\mathbf{F}_2^p)$:

$$\mathbf{L} = \mathcal{L}_{\mathbf{F}_2}(A) \xrightarrow{\sim} \mathcal{L}_{\mathbf{F}_2}(\mathbf{F}_2^p) = \mathbf{M}_p(\mathbf{F}_2) \qquad (6)$$

Ainsi, en remplaçant chaque élément $h_{m,n}$ de la matrice **H** par son image via l'identification (6) ci-dessus, on obtient une matrice binaire $\mathbf{H_{bin}} \in \mathbf{M}_{Mp,Np}(\mathbf{F}_2)$. Cette matrice est la matrice de parité du code binaire $C_{\mathrm{bin}}$.

On notera que les codes non binaires définis sur $\mathbf{F}_q$, c'est-à-dire sur le corps fini à $q$ éléments, représentent un cas particulier de codes non binaires. L'alphabet d'un tel code est $A = \mathbf{F}_q$, et sa structure de $\mathbf{F}_2$-espace vectoriel est induite par l'addition interne sur $\mathbf{F}_q$. En outre, l'opération de multiplication sur $\mathbf{F}_q$ définit un plongement de $\mathbf{F}_q$ comme sous-espace vectoriel de $\mathbf{L} = \mathcal{L}_{\mathbf{F}_2}(A)$ (i.e. $\mathbf{F}_q \subset \mathbf{L}$). On dit que « *le code C est défini sur* $\mathbf{F}_q$ » s'il est défini comme le noyau d'une matrice $\mathbf{H} \in \mathbf{M}_{M,N}(\mathbf{F}_q) \subset \mathbf{M}_{M,N}(\mathbf{L})$. Dans ce cas là, tous les éléments de la matrice **H** appartiennent à $\mathbf{F}_q$, $h_{m,n} \in \mathbf{F}_q$, et les multiplications $h_{m,n}X_n$ dans (5) sont simplement des multiplications internes dans le corps $\mathbf{F}_q$.

Dans un but d'illustration, nous donnerons un exemple de représentation binaire d'un code non binaire simple.

Nous considérerons un alphabet $A$ à 8 éléments, isomorphe par conséquent à $\mathbf{F}_8$. Nous adopterons classiquement une représentation primitive de $\mathbf{F}_8$. Plus précisément, $\mathbf{F}_8$ est isomorphe à $\mathbf{F}_2[D]/P(\mathrm{D})$ anneau quotient de $\mathbf{F}_2[D]$ par l'idéal engendré par le polynôme irréductible $P(D)=1+D+D^3$. L'addition et la multiplication dans $\mathbf{F}_8$ sont définies par l'addition et la multiplication des polynômes, modulo $P(D)$. Pour simplifier, nous supposerons que $\mathbf{F}_8 = \{0,1,...,7\}$. Ainsi, l'image binaire d'un symbole $X \in \mathbf{F}_8 = \{0,1,...,7\}$ est la séquence binaire $(x_0,x_1,x_2)$ correspondant à l'expression polynomiale $X = \sum_{i=0}^{p-1} x_i 2^i$ ) **.** De manière générale, $X$ est représenté par le polynôme $X(D) = \sum_{i=0}^{p-1} x_i D^i$ **,** dont les coefficients sont donnés par son image binaire. La somme de deux symboles $X, Y \in \mathbf{F}_8 = \{0,1,....7\}$ correspond à la somme bit-à-bit de $X$ et $Y$. Leur produit est défini par le reste modulo $P(D)$ du produit des deux polynômes $X(D) = \sum_{i=0}^{p-1} x_i D^i$ et

$$Y(D)=\sum_{i=0}^{p-1} y_i D^i \ .$$

Nous allons considérer un code non-binaire défini par une unique contrainte linéaire sur $\mathbf{F}_8$ :

$$3X + 4Y + 6Z = 0 \qquad (7)$$

On rappelle que dans ce cas $\mathbf{L}=A=\mathbf{F}_8$.

En utilisant la représentation binaire des éléments de $\mathbf{F}_8$ et plus précisément l'isomorphisme (6) pour représenter $3,4,6 \in \mathbf{L}$ et l'isomorphisme (3) pour représenter $X,Y,Z \in A$, l'égalité ci-dessus devient :

$$\begin{aligned}&(1+D)(x_0+x_1D+x_2D^2)\\&+D^2\left(y_0+y_1D+y_2D^2\right)\\&+(D^2+D)\left(z_0+z_1D+z_2D^2\right)=0\end{aligned} \qquad (8)$$

soit encore, en tenant compte de $D^3$=1+D [$P(D)$] :

$$\begin{cases}x_0+x_2+y_1+z_1+z_2=0\\x_0+x_1+x_2+y_1+y_2+z_0+z_1=0\\x_1+x_2+y_0+y_2+z_0+z_1+z_2=0\end{cases} \qquad (9)$$

L'expression (10) peut donc aussi se traduire de manière matricielle :

$$\begin{pmatrix}1&0&1\\1&1&1\\0&1&1\end{pmatrix}\begin{pmatrix}x_0\\x_1\\x_2\end{pmatrix}+\begin{pmatrix}0&1&0\\0&1&1\\1&0&1\end{pmatrix}\begin{pmatrix}y_0\\y_1\\y_2\end{pmatrix}+\begin{pmatrix}0&1&1\\1&1&0\\1&1&1\end{pmatrix}\begin{pmatrix}z_0\\z_1\\z_2\end{pmatrix}=0 \qquad (10)$$

La matrice de contrainte $\mathbf{H} \in \mathbf{M}_{1,3}(\mathbf{F}_8)$ et son image binaire $\mathbf{H_{bin}} \in \mathbf{M}_{3,9}(\mathbf{F}_2)$ s'obtiennent respectivement à partir des équations (7) et (10). On a en définitive :

$$\mathbf{H}=\begin{pmatrix}3&4&6\end{pmatrix} \qquad (11)$$

et

$$\mathbf{H_{bin}}=\begin{pmatrix}1&0&1&0&1&0&0&1&1\\1&1&1&0&1&1&1&1&0\\0&1&1&1&0&1&1&1&1\end{pmatrix} \qquad (12)$$

Les graphes bipartites correspondant respectivement à la matrice de contrainte H du code non-binaire et à la matrice de parité $\mathbf{H_{bin}}$ de son image binaire sont respectivement illustrés en Figs. 4A et 4B. On notera dans la présence dans le graphe binaire de nombreux cycles courts (de longueur 4) alors que le graphe non-binaire est acyclique.

De manière générale, l'image binaire d'un code non-binaire, acyclique ou à faible nombre de cycles, peut comprendre un nombre important de cycles du simple fait de la représentation binaire choisie. L'homme du métier comprendra que certaines représentations binaires puissent être équivalentes du point de vue algébrique mais conduire à des performances différentes en termes de décodage.

Le problème à la base de l'invention est par conséquent de proposer une méthode de décodage d'un code non binaire susceptible de représentation par graphe bipartite, par exemple d'un code LDPC non binaire, qui ne présente pas les inconvénients précités, c'est-à-dire qui allie une faible complexité de décodage à un faible taux d'erreurs.

## EXPOSÉ DE L'INVENTION

La présente invention est définie par une méthode de décodage d'un code non binaire, en particulier d'un code LDPC non binaire, susceptible d'une représentation par graphe bipartite avec *N* noeuds de variables et *M* noeuds de contraintes, les variables prenant leurs valeurs dans un alphabet *A* non binaire et étant linéairement contraintes au moyen d'une matrice de contraintes, chaque variable étant représentée par une pluralité *p* de valeurs binaires. Selon cette méthode :

- on génère pour chaque variable une pluralité $\overline{p} > p$ de valeurs binaires, dites valeurs binaires étendues, obtenues par $\overline{p}$ combinaisons linéaires distinctes à coefficients dans $\mathbf{F}_2$ desdites *p* valeurs binaires, hormis la combinaison nulle ;
- on calcule une matrice de parité, $\overline{\mathbf{H}}_{bin}$, dite matrice de parité étendue, représentant des contrôles de parité sur les valeurs binaires étendues des variables, dits contrôles de parité étendus, lesdits contrôles de parité étendus étant induits par les contraintes sur lesdites variables ;
- on effectue un décodage itératif à passage de messages à l'aide d'un second graphe bipartite, dit graphe étendu, représentant la matrice de parité étendue et reliant les contrôles de parité étendus aux valeurs binaires étendues des variables ;
- on détermine les valeurs binaires de chaque variable à partir de ses valeurs binaires étendues, obtenues au terme du décodage itératif.

Par exemple, l'alphabet *A* pourra être constitué de $q=2^p$ éléments et $\overline{p}=q-1$.

On complète avantageusement ladite matrice de parité étendue, $\overline{\mathbf{H}}_{bin}$, en ajoutant des lignes supplémentaires, lesdites lignes supplémentaires étant obtenues au moyen de combinaisons linéaires distinctes à coefficients dans $\mathbf{F}_2$ des lignes existantes, hormis la combinaison nulle, chaque ligne de la matrice ainsi complétée définissant un contrôle de parité étendu, le graphe étendu reliant alors l'ensemble des valeurs binaires étendues des variables à l'ensemble des contrôles de parité étendus de la matrice $\overline{\mathbf{H}}_{bin}$ ainsi complétée.

Par exemple, le nombre de lignes supplémentaires ajoutées sera de $q-p-1$.

De préférence, au moins une partie des valeurs binaires étendues de chaque variable est initialisée à l'aide des valeurs binaires de celle-ci.

Selon une première variante, pour au moins une itération du décodage itératif, les valeurs binaires étendues de chaque variable sont soumises à un décodage à maximum de vraisemblance pour obtenir des valeurs binaires étendues estimées vérifiant un ensemble de contraintes induites par lesdites $\overline{p}$ combinaisons linéaires. On remplace alors, pour chaque variable, lesdites valeurs binaires étendues par lesdites valeurs binaires étendues estimées pour poursuivre le décodage itératif.

Selon une seconde variante, pour au moins une itération du décodage itératif, les messages transmis par les valeurs binaires étendues de chaque variable sont corrigés au sens du maximum de vraisemblance pour vérifier un ensemble de contraintes induites par lesdites $\overline{p}$ combinaisons linéaires. On remplace alors, pour chaque variable, lesdits messages transmis au moyen des dits messages corrigés pour poursuivre le décodage itératif.

Selon une troisième variante, pour au moins une itération du décodage itératif, les messages reçus par les valeurs binaires étendues de chaque variable sont corrigés au sens du maximum de vraisemblance pour vérifier un ensemble de contraintes induites par lesdites $\overline{p}$ combinaisons linéaires. On remplace alors, pour chaque variable, lesdits messages reçus au moyen des dits messages corrigés pour poursuivre le décodage itératif.

Selon un mode de réalisation particulier, on utilise en outre un graphe auxiliaire reliant les valeurs binaires aux valeurs binaires étendues des variables, ledit graphe auxiliaire représentant les combinaisons linéaires permettant de générer les secondes à partir des premières.

Dans ce cas, l'étape de décodage itératif peut comprendre au moins une première phase de passage de messages entre les valeurs binaires et les valeurs binaires étendues des variables, à travers ledit graphe auxiliaire, et une seconde phase de passage de messages entre les valeurs binaires des variables et les contrôles de parité étendus, à travers ledit graphe étendu.

## BRÈVE DESCRIPTION DES DESSINS

La Fig. 1 représente le graphe bipartite d'un exemple de code LDPC non binaire ;

La Fig. 2 représente schématiquement le principe de l'information extrinsèque dans un décodage itératif à passage de messages;

La Fig. 3 représente un exemple de cycle dans un graphe bipartite ;

Les Figs. 4A et 4B représentent respectivement un graphe bipartite d'un code non binaire et le graphe bipartite correspondant de son image binaire ;

La Fig. 5 représente les matrices de parité respectives d'un exemple de code non binaire, de son image binaire et de son image binaire étendue ;

La Fig. 6 représente schématiquement une méthode de décodage d'un code non-binaire utilisant une représentation binaire étendue, selon un mode de réalisation de l'invention.

La Fig. 7 représente un premier exemple de graphe bipartite associé à une représentation binaire étendue d'un code non binaire et permettant un décodage selon la méthode de la Fig. 6.

La Fig. 8 représente un second exemple de graphe bipartite associé à la même représentation binaire étendue du code non binaire et permettant également un décodage selon la méthode de la Fig. 6.

## EXPOSÉ DÉTAILLÉ DE MODES DE RÉALISATION PARTICULIERS

On considère à nouveau un code correcteur d'erreurs, non binaire, défini sur un alphabet *A*, corps de cardinal *q*, et susceptible d'une représentation par un graphe bipartite avec *N* variables et *M* contraintes. Nous supposerons dans la suite, sans perte de généralité, que ce code correcteur est un code LDPC non binaire.

Par définition, le code non binaire est défini par un ensemble de *M* équations linéaires (ou contraintes) à *N* inconnues (ou variables) prenant leurs valeurs dans *A*. On supposera, là encore sans perte de généralité, que $q=2^p$. On peut alors identifier chaque symbole du code à un vecteur de *p* valeurs binaires, c'est-à-dire un élément de $\mathbf{F}_2^p$, grâce à l'isomorphisme d'espace vectoriel (3). Le vecteur ou *p*-uplet de valeurs binaires donne la représentation binaire d'un symbole de l'alphabet non-binaire. La multiplication d'un symbole de *A* par un coefficient appartenant à **L** au sein d'une équation linéaire peut être identifiée à un $\mathbf{F_2}$-endomorphisme sur *A*, conformément à la convention (4). Ce coefficient de **L** et donc cet $\mathbf{F_2}$-endomorphisme sur *A* peut être représenté de manière générale par une matrice de taille $p\times p$ à coefficients dans $\mathbf{F_2}$.

L'idée principale à la base de l'invention est d'utiliser une représentation binaire étendue des symboles de *A* ainsi que des $\mathbf{F_2}$-endomorphismes sur *A*. Par représentation binaire étendue d'un élément du corps *A*, on entend de manière générale une représentation binaire redondante de cet élément utilisant un nombre $\overline{p}$ de bits strictement supérieur à *p* (de manière générale supérieur à $\log_2(q)$).

Chacun des $\overline{p}$ bits de cette représentation binaire étendue s'exprime avantageusement comme une combinaison linéaire des *p* valeurs binaires de la représentation binaire avec des coefficients dans $\mathbf{F_2}$. Par exemple un symbole *X* de *A* pourra être représenté par $(x_0,x_1,...,x_{p-1})$ dans la représentation binaire et par $(a_1,a_1..,a_{q-1})$ dans la représentation binaire étendue avec :

$$a_i=\sum_{j=0}^{p-1}s_i^j x_j\ ,\quad s_i^j\in\mathbf{F}_2 \tag{13}$$

où les $\left(s_i^0,s_i^1,\ldots,s_i^{p-1}\right)$ $i=1,...,q-1$ décrivent les $q$-1 combinaisons possibles de *p* bits (*q* combinaisons hormis la combinaison nulle). Dans ce cas là, on a $\overline{p}$=q-1.

La relation (13) peut encore s'exprimer sous forme matricielle :

$$\left(a_1,a_1,\ldots,a_{q-1}\right)=(x_0,x_1,\ldots,x_{p-1})\mathbf{S}_p \tag{14}$$

où $\mathbf{S}_p$ est la matrice de taille $p\times(q-1)$ dont les colonnes sont $q$-1 combinaisons possibles de *p* bits. Autrement dit, $\mathbf{S}_p$ est la matrice génératrice du code $(a_1,a_1,...,a_{q-1})$.

Toute représentation binaire étendue de *A* induit de manière canonique une représentation binaire étendue des endomorphismes sur *A*. En effet, soit un vecteur $u_e$ de dimension $\overline{p}$ une représentation binaire étendue d'un élément $X\in A$, $\varphi(X)$ est un élément de *A* qui possède également un représentation binaire étendue, $v_e$. L'endomorphisme $\varphi$

peut ainsi être représenté par une matrice binaire de taille $\bar{p}\times\bar{p}$.

Un code non binaire à $M$ contraintes et $N$ variables peut alors être décrit par une matrice binaire étendue $\mathbf{H}_e \in \mathbf{M}_{M\bar{p},N\bar{p}}(\mathbf{F}_2)$, de dimension $M\bar{p}\times N\bar{p}$.

Nous envisagerons une représentation binaire étendue d'un code non binaire $C \subset A^N$ où $A$ est un ensemble de cardinal $q=2^p$ et par conséquent isomorphe à $\mathbf{F}_2^p$. Le code non binaire est défini par une matrice $\mathbf{H} \in \mathbf{M}_{M,N}(\mathbf{L})$ dont les éléments $h_{m,n} \in \mathbf{L}$ sont des endomorphismes sur $A$ :

$$\begin{aligned} C &= \mathrm{Ker}(\mathbf{H}) \subset A^N \\ &= \left\{ (X_1,\ldots,X_N) \mid \sum_{n=1}^{N} h_{m,n} X_n = 0, \forall m = 1,\ldots,M \right\} \end{aligned} \tag{15}$$

Chacune des $M$ équations figurant dans (15) correspond à une contrainte (c'est-à-dire à une équation linéaire sur les variables non binaires $X_n$). La matrice **H** est la « matrice de parité » du code non binaire $C$.

Soit $h \in \mathbf{L}$ et $\mathbf{m_h} \in \mathbf{M}_p(\mathbf{F}_2)$ son image binaire au sens de l'isomorphisme (6).

Pour fixer les idées, si $p$=3 et si $h$ est l'endomorphisme sur $A$ qui à tout élément $X$ fait correspondre l'élément $3X$, l'image binaire de $h$ peut s'écrire, comme vu plus haut, en relation avec les expressions (11) et (12) :

$$\mathbf{m_h} = \begin{pmatrix} 1 & 0 & 1 \\ 1 & 1 & 1 \\ 0 & 1 & 1 \end{pmatrix} \tag{16}$$

Revenant au cas général, et considérant l'ensemble $\mathbf{Z}_q = \{0,1,\ldots,q\text{-}1\}$ des entiers modulo $q$, la matrice $\mathbf{m_h} \in \mathbf{M}_p(\mathbf{F}_2)$ induit un endomorphisme $\phi_h$ sur $\mathbf{Z}_q$ :

$$\begin{array}{ccc} \mathbf{F}_2^p & \xrightarrow{m_h} & \mathbf{F}_2^p \\ \eta \downarrow & & \downarrow \eta \\ \mathbf{Z}_q & \xrightarrow{\phi_h} & \mathbf{Z}_q \end{array} \tag{17}$$

où $\eta$ est la bijection qui à tout $p$-uplet $(b_0,b_1,..,b_{p-1})$ associe l'entier $z=b_0+b_1 2^1+b_2 2^2+\ldots+b_{p-1}2^{p-1}$. Réciproquement $\eta^{-1}$ associe à chaque entier de $\mathbf{Z}_q$ sa décomposition binaire sur $p$ bits.

L'opération de XOR bit-à-bit sur $\mathbf{F}_2^p$ munit $\mathbf{Z}_q$ d'une structure de $\mathbf{F}_2$-espace vectoriel. On définit l'opération ^ sur $\mathbf{Z}_q$ par :

$$i \wedge j = \eta\left(\eta^{-1}(i)\ XOR\ \eta^{-1}(j)\right) \tag{18}$$

$\phi_h$ vérifie alors la propriété :

$$\phi_h(i \wedge j) = \phi_h(i) \wedge \phi_h(j), \quad \forall i,j \in \mathbf{Z}_q \tag{19}$$

On définit une matrice $\mathbf{M_h} \in \mathbf{M}_{q-1}(\mathbf{F}_2)$ de taille $(q\text{-}1)\times(q\text{-}1)$ par :

$$M_h(i,j) = \begin{cases} 1, & \text{if } j = \phi_h(i) \\ 0, & \text{sinon} \end{cases} \qquad \forall i,j \in \mathbf{Z}_q^* \tag{20}$$

où $\mathbf{Z}_q^* = \mathbf{Z}_q - \{0\}$. Cette représentation ne fait pas intervenir l'élément nul de $\mathbf{Z}_q$, car l'on a trivialement $\phi_h(0)=0$.

La matrice $\mathbf{M}_h$ est appelée « matrice binaire étendue » associée à l'endomorphisme $h \in \mathbf{L}$. Dans la définition précédente, on notera que l'ensemble $\mathbf{Z}_q^*$ est uniquement utilisé afin d'indexer les lignes et les colonnes de la matrice $\mathbf{M}_h \in \mathbf{M}_{q-1}(\mathbf{F}_2)$ par des entiers $(i,j) \in \mathbf{Z}_q \times Z_q$, plutôt que par des symboles de l'alphabet *A*.

On remarquera que si $h \in \mathbf{L}$ est un endomorphisme inversible (ou, de manière équivalente si $m_h \in \mathbf{M}_p(\mathbf{F}_2)$ est une matrice inversible), alors $\phi_h$ induit une permutation sur $\mathbf{Z}_q$ et par suite $\mathbf{M}_h$ est une matrice de permutation, ne contenant qu'un seul « 1 » par ligne et par colonne.

Nous illustrerons la construction de la matrice binaire étendue dans le cadre de l'exemple précédent $A$=$\mathbf{F}_8$, $h = 3 \in \mathbf{L}$, dont on rappelle que l'image binaire est :

$$m_h = \begin{pmatrix} 1 & 0 & 1 \\ 1 & 1 & 1 \\ 0 & 1 & 1 \end{pmatrix}$$

Les lignes de $m_h$ définissent respectivement $\phi(1)$, $\phi(2)$ et $\phi(4)$. Ainsi $\phi(1)=5$, entier dont la décomposition binaire correspond à la première ligne de $m_h$. De la même manière, on $\phi(2)=7$ et $\phi(4)=6$.

On déduit les valeurs sur les autres éléments de $\mathbf{Z}_8$ indexant *A* à l'aide de (19) :

$$\begin{aligned} \phi(3) &= \phi(1) \wedge \phi(2) = 2 \\ \phi(5) &= \phi(1) \wedge \phi(4) = 3 \\ \phi(6) &= \phi(2) \wedge \phi(4) = 1 \\ \phi(7) &= \phi(1) \wedge \phi(2) \wedge \phi(4) = 4 \end{aligned} \qquad (21)$$

Finalement, la matrice binaire étendue $\mathbf{M}_h$ associée à *h* est donnée par :

$$\mathbf{M}_h = \begin{pmatrix} 0 & 0 & 0 & 0 & 1 & 0 & 0 \\ 0 & 0 & 0 & 0 & 0 & 0 & 1 \\ 0 & 1 & 0 & 0 & 0 & 0 & 0 \\ 0 & 0 & 0 & 0 & 0 & 1 & 0 \\ 0 & 0 & 1 & 0 & 0 & 0 & 0 \\ 1 & 0 & 0 & 0 & 0 & 0 & 0 \\ 0 & 0 & 0 & 1 & 0 & 0 & 0 \end{pmatrix} \qquad (22)$$

On procède ainsi pour chacun des $M \times N$ coefficients (c'est-à-dire pour chacun des endomorphismes) $h_{m,n} \in \mathbf{L}$. La matrice obtenue en remplaçant chaque élément $h_{m,n}$ de $\mathbf{H} \in \mathbf{M}_{M,N}(\mathbf{L})$ par la matrice binaire étendue associée $\mathbf{M}_h \in \mathbf{M}_{q-1}(\mathbf{F}_2)$, définie par (20), est une matrice notée $\mathbf{H_{bin}} \in \mathbf{M}_{M(q-1),N(q-1)}(\mathbf{F}_2)$, appelée matrice binaire étendue associée à la matrice de parité **H** du code non binaire *C*.

Le code binaire $\overline{C}_{\text{bin}} = \text{Ker}(\overline{\mathbf{H}}_{\mathbf{bin}}) \subset \mathbf{F}_2^{N(q-1)}$ est appelé code binaire étendu associé au code non-binaire $C = \text{Ker}(\mathbf{H}) \subset A^N$.

La Fig. 5 donne un exemple de matrice de parité **H**, de son image binaire $\mathbf{H}_{bin}$ et de son image binaire étendue $\overline{\mathbf{H}}_{bin}$, construite comme décrit précédemment. Par souci de simplification, seules les valeurs non nulles ont été indiquées dans cette dernière.

La matrice de parité **H** est celle d'un code LDPC non binaire défini sur $\mathbf{F}_8$, à $N$=6 variables et $M$=3 contrôles.

Son image binaire, $\mathbf{H}_{bin}$, est une matrice de taille $9 \times 18$, construite à partir de matrices élémentaires $3 \times 3$, chaque matrice élémentaire correspondant à un coefficient de **H**, c'est-à-dire un endomorphisme sur $\mathbf{F}_8$ et donnant une

représentation binaire de ce dernier (selon (6)). Chaque matrice élémentaire est « pondérée » au sens où les numéros de ligne et de colonne correspondent à des poids binaires $2^0, 2^1, 2^2$.

L'image binaire étendue $\overline{\mathbf{H}}_{bin}$ est une matrice de taille 21×42, construite à partir de matrices élémentaires de taille 7×7, chaque matrice élémentaire correspondant là encore à un coefficient de la matrice H, c'est-à-dire un endomorphisme sur $\mathbf{F}_8$ et donnant une représentation binaire étendue de ce dernier (selon (20)). Au contraire de l'image binaire, les lignes et colonnes des matrices élémentaires ne sont ici pas « pondérées » mais correspondent chacune à un élément de $\mathbf{F}_8$ (hormis l'élément nul).

On remarque que la matrice $\overline{\mathbf{H}}_{bin}$ est peu dense. Dans le cas présent, elle ne contient par ligne que quatre valeurs non nulles (« 1 ») dispersées parmi 42. Le graphe associé à cette matrice présente par conséquent sensiblement moins de cycles que l'image binaire $\mathbf{H}_{bin}$.

Les mots du code non binaire *C* peuvent s'exprimer à l'aide de la représentation binaire étendue des éléments de *A*. En effet, soit $(X_1,...,X_N) \in C \subset A^N$ un mot du code non binaire. $\forall n \in \{1,...,N\}$, notons $(x_{n,0}, x_{n,1},..., x_{n,p-1}) \in \mathbf{F}_2^p$ l'image binaire de $X_n$ et $(a_{n,1}, a_{n,2},..., a_{n,q-1}) \in \mathbf{F}_2^{q-1}$ son image binaire étendue, obtenue par (14), c'est-à-dire :

$$(a_{n,1}, a_{n,2},..., a_{n,q-1}) = (x_{n,0}, x_{n,1},..., x_{n,p-1})\mathbf{S}_p \qquad (23)$$

alors $(a_{1,1}, a_{1,2}, \ldots, a_{1,q-1},..., a_{N,1}, a_{N,2},..., a_{N,q-1}) \in \overline{C}_{\text{bin}} \subset \mathbf{F}_2^{N(q-1)}$. On notera dans la suite $S_p$ le code binaire dont la matrice génératrice est $\mathbf{S}_p$.

Réciproquement, soit la séquence binaire :

$$(a_{1,1}, a_{1,2}, \ldots, a_{1,q-1},..., a_{N,1}, a_{N,2},..., a_{N,q-1}) \in \overline{C}_{\text{bin}} \subset \mathbf{F}_2^{N(q-1)} \qquad (24)$$

telle que $\forall n \in \{1,...,N\}$, $(a_{n,1}, a_{n,2},..., a_{n,q-1}) \in S_p \subset \mathbf{F}_2^{q-1}$, autrement dit, telle que :

$$\exists (x_{n,0}, x_{n,1},..., x_{n,p-1}) \in \mathbf{F}_2^p \text{ tel que } (a_{n,1}, a_{n,2},..., a_{n,q-1}) = (x_{n,0}, x_{n,1},..., x_{n,p-1})\mathbf{S}_p$$

Soit $X_n \in A$, le symbole dont l'image binaire est $(x_{n,0}, x_{n,1},..., x_{n,p-1}) \in \mathbf{F}_2^p$. Alors $(X_1,...,X_N) \in C \subset A^N$ est un mot de code non-binaire et $(a_{n,1}, a_{n,2},..., a_{n,q-1}) \in \mathbf{F}_2^{q-1}$ est l'image binaire étendue de $X_n$, pour tout $n \in \{1,...,N\}$. Il en résulte que l'application qui associe à un mot de code non-binaire $(X_1,...,X_N) \in C$ son image binaire étendue $(a_{1,1},a_{1,2},...,a_{1,q-1},a_{N,1},a_{N,2},...,a_{N,q-1}) \in \overline{C}_{\text{bin}}$ est un isomorphisme de C sur $\overline{C}_{\text{bin}} \cap S_p^N$ où $S_p^N = S_p \times \ldots \times S_p \subset \mathbf{F}_2^{N(q-1)}$ est l'espace vectoriel produit de *N* copies de $S_p$.

Nous donnerons ci-après un exemple simple de représentation binaire d'un code non binaire. Soit le code non binaire défini sur $A=\mathbf{F}_8$ par l'unique équation de parité (7). On a $p$=3 et $q$=8. La matrice $\mathbf{S}_3$ est définie par :

$$\mathbf{S}_3 = \begin{pmatrix} 1 & 0 & 1 & 0 & 1 & 0 & 1 \\ 0 & 1 & 1 & 0 & 0 & 1 & 1 \\ 0 & 0 & 0 & 1 & 1 & 1 & 1 \end{pmatrix} \qquad (25)$$

La représentation binaire étendue $(a_1,a_2,...,a_1)$ d'un élément *X* de *A* peut être obtenue à partir de sa représentation binaire $(x_0,x_1,x_2)$ au moyen de $(a_1,a_2,...,a_7)=(x_0,x_1,x_2)\mathbf{S}_3$, soit encore :

$$a_1 = x_0,\ a_2 = x_1,\ a_3 = x_0 + x_1,\ a_4 = x_2,\ a_5 = x_0 + x_2,\ a_6 = x_1 + x_2,\ a_7 = x_0 + x_1 + x_2 \quad (26)$$

On comprendra que les variables $a_1,a_2,...,a_7$ représentent les $\mathbf{F}_2$-combinaisons linéaires possibles des valeurs binaires $x_0,x_1,x_2$.

La représentation binaire étendue $(b_1,b_2,...,b_1)$ de $Y$ et celle, $(c_1,c_2,...,c_7)$, de $Z$ est obtenue de la même façon, à savoir $(b_1,b_2,...,b_7)=(y_0,y_1y_2)\mathbf{S}_3$ et $(c_1,c_2,...,c_1)=(z_0,z_1,z_2)\mathbf{S}_3$.

Le système d'équations (10) peut alors être réécrit sous la forme :

$$\begin{cases} (x_0 + x_2) + y_1 + (z_1 + z_2) = 0 \\ (x_0 + x_1 + x_2) + (y_1 + y_2) + (z_0 + z_1) = 0 \\ (x_1 + x_2) + (y_0 + y_2) + (z_0 + z_1 + z_2) = 0 \end{cases} \quad (27)$$

soit, de manière équivalente, en faisant intervenir la représentation binaire étendue :

$$\begin{cases} a_5 + b_2 + c_6 = 0 \\ a_7 + b_6 + c_5 = 0 \\ a_6 + b_5 + c_7 = 0 \end{cases} \quad (28)$$

ce qui donne sous forme matricielle :

$$\left(\begin{array}{ccccccc|ccccccc|ccccccc} 0&0&0&0&1&0&0&0&1&0&0&0&0&0&0&0&0&0&0&1&0 \\ 0&0&0&0&0&0&1&0&0&0&0&0&1&0&0&0&0&0&1&0&0 \\ 0&0&0&0&0&1&0&0&0&0&0&1&0&0&0&0&0&0&0&0&1 \end{array}\right)\mathbf{u} = 0 \quad (29)$$

où $\mathbf{u}=(a_1,...,a_7,b_1...,b_7,c_1,..,c_7)\in \overline{C}_{bin}$. Cette matrice contient 3 matrices élémentaires correspondant chacune à un endomorphisme sur $\mathbf{F}_8$ (les coefficients du code non-linéaire) et 3 lignes correspondant aux 3 équations du système (28).

On remarque que la matrice précédente ne définit pas de contrôle de parité pour certains bits de la représentation binaire étendue de $X,Y,Z$. Afin que chacun des 21 bits $a_1,..,a_7,b_1,..,b_7,c_1,..,c_7$ participe à un contrôle de parité, on rajoute à cette matrice des lignes supplémentaires qui peuvent se déduire par combinaisons linéaires des lignes déjà présentes. Ainsi par exemple, en additionnant les deux premières lignes de la matrice (29), ou de manière équivalente en ajoutant les deux premières équations du système (28), on obtient :

$$(a_5 + a_7) + (b_2 + b_6) + (c_5 + c_6) = 0 \quad (30)$$

ce qui, compte tenu de $a_5+a_7=x_0+x_2+x_0+x_1+x_2=x_1=a_2$, $b_2+b_6=b_4$ et $c_5+c_6=c_3$ peut se réécrire comme ligne n°3 de la matrice :

$$a_2 + b_4 + c_3 = 0 \quad (31)$$

De manière similaire, en additionnant les lignes n°1 et n°4, on obtient une ligne n°5 :

$$a_3 + b_7 + c_1 = 0 \quad (32)$$

en additionnant les lignes n°2 et n°4, on obtient une ligne n°6 :

$$a_1 + b_3 + c_2 = 0 \qquad (33)$$

et enfin, en additionnant les lignes 1,2 et 4, on obtient une ligne 7 :

$$a_4 + b_1 + c_4 = 0 \qquad (34)$$

En définitive, la matrice ainsi complétée n'est autre que la matrice binaire étendue $\overline{\mathbf{H}}_{bin}$ :

$$\overline{\mathbf{H}}_{\mathrm{bin}} = \left(\begin{array}{ccccccc|ccccccc|ccccccc} 0&0&0&0&1&0&0&0&1&0&0&0&0&0&0&0&0&0&0&1&0 \\ 0&0&0&0&0&0&1&0&0&0&0&0&1&0&0&0&0&0&1&0&0 \\ 0&1&0&0&0&0&0&0&0&0&1&0&0&0&0&0&1&0&0&0&0 \\ 0&0&0&0&0&1&0&0&0&0&0&1&0&0&0&0&0&0&0&0&1 \\ 0&0&1&0&0&0&0&0&0&0&0&0&0&1&1&0&0&0&0&0&0 \\ 1&0&0&0&0&0&0&0&0&1&0&0&0&0&0&1&0&0&0&0&0 \\ 0&0&0&1&0&0&0&1&0&0&0&0&0&0&0&0&0&1&0&0&0 \end{array}\right) \qquad (35)$$

Le graphe bipartite associé à cette matrice de parité ne contient aucun cycle, chaque bit $a_i$, $b_i$ ou $c_i$ n'apparaissant que dans un seul contrôle de parité. De manière générale une matrice binaire étendue $\overline{\mathbf{H}}_{bin}$ ne contient un cycle que dans la mesure où la matrice non binaire **H** en contient elle-même : les cycles apparaissant dans $\overline{\mathbf{H}}_{bin}$ sont en fait induits par les cycles déjà présents dans **H**.

Après avoir donné une représentation binaire étendue du code non binaire, nous exposerons ci-après la méthode de décodage selon l'invention mettant en oeuvre cette représentation.

La Fig. 6 représente schématiquement sous forme d'organigramme une méthode de décodage d'un code non-binaire selon un mode de réalisation de l'invention.

On considère comme précédemment un code correcteur d'erreurs *C*, non binaire et susceptible d'une représentation par graphe bipartite, *G*, le code étant défini par un ensemble de *N* variables $X_1,...,X_N$ prenant leurs valeurs dans un alphabet non binaire *A* et un ensemble de *M* contraintes dépendant linéairement desdites variables au moyen d'une matrice de contraintes **H** à coefficients dans **L**. On note $q=Card(A)$ et *p* le plus petit entier tel que $p \geq \log_2(q)$, autrement dit *p* est le plus petit nombre de bits permettant une représentation binaire des symboles de *A*.

Les valeurs des variables $X_1,...,X_N$ sont prises en compte à l'étape 610. Ces valeurs peuvent être reçues d'un émetteur à travers un canal de transmission ou bien lues d'un support d'enregistrement. Plus précisément chaque variable $X_n$ est représentée par *p* valeurs binaires $x_{n,0},x_{n,1},...,x_{n,p}$ où $x_{n,0}$ est le LSB et $x_{n,p}$ est le MSB. Ces valeurs binaires peuvent être dures ou souples de manière connue en soi. De même chaque contrainte non-binaire $Y_m$ correspond à *p* contrôles de parité $y_{m,0},y_{m,1},...,y_{m,p}$ qui doivent être vérifiés par les valeurs binaires $y_{n,0},y_{n,1},...,y_{n,p}$.

La matrice de contraintes **H** est par ailleurs connue du décodeur.

A l'étape 620, on génère pour chaque variable $X_n$ une représentation binaire étendue $(a_{n,1},...,a_{n,\overline{p}})$ de $X_n$ au moyen d'une pluralité $\overline{p}$ de combinaisons linéaires distinctes à coefficients dans $\mathbf{F}_2$ de ses valeurs binaires $x_{n,0},x_{n,1},...,y_{n,p}$, telle que $\overline{p}>p$. Les valeurs $a_{n,1},...,a_{n,\overline{p}}$ sont dénommées valeurs binaires de la représentation binaire étendue de $X_n$ ou, plus simplement, valeurs binaires étendues de $X_n$. On peut générer ainsi jusqu'à $q$-1 valeurs binaires étendues.

A l'étape 630, on calcule une matrice de parité étendue $\overline{\mathbf{H}}_{bin}$ permettant d'obtenir les contrôles de parité associés à chaque contrainte (non-binaire) en fonction des valeurs binaires étendues des différentes variables $X_1,...,X_N$. Les contrôles ainsi obtenus sont dénommés contrôles de parité étendus.

A l'étape 640, on complète avantageusement mais non nécessairement, la matrice de parité $\overline{\mathbf{H}}_{bin}$, en ajoutant des lignes supplémentaires, lesdites lignes supplémentaires étant obtenues au moyen de combinaisons linéaires distinctes à coefficients dans $\mathbf{F}_2$ des lignes existantes, hormis la combinaison nulle. On peut ainsi ajouter jusqu'à $q$-$p$-1 lignes supplémentaires pour obtenir un total de $q$-1 lignes par contrainte, chaque ligne de la matrice ainsi complétée étant associée à un contrôle de parité étendu, c'est-à-dire portant sur des valeurs binaires étendues des variables.

De manière plus générale, on peut obtenir une matrice parité $\overline{\mathbf{H}}_{bin}$ à partir de $\overline{p}$ combinaisons linéaires distinctes par contrainte, chacune d'entre elles étant une combinaison à coefficients dans $\mathbf{F}_2$ des lignes existantes (hormis la combinaison nulle). Ces combinaisons peuvent ne pas inclure certaines lignes existantes, voire toutes ces dernières.

A l'étape 650, on effectue un décodage itératif à passage de messages au moyen d'un graphe bipartite $\overline{G}$ reliant les valeurs binaires étendues des variables aux valeurs binaires étendues des contrôles. Les messages échangés entre les noeuds de variables et les noeuds de contrôle peuvent être des probabilités, des rapports de vraisemblance logarithmiques (LLRs), ou simplement des valeurs binaires. Les messages peuvent être calculés de manière connue en soi à l'aide d'algorithmes de type « Sum-Product », « Min-Sum », ou encore de leurs variantes corrigées « Normalized Min-Sum », « Self-corrected Min-Sum ». On trouvera par exemple une description des deux premiers dans la thèse de N. Wiberg précitée. Pour la variante « Normalized Min-Sum » on pourra se référer notamment à l'article de J. Chen et al. Intitulé « Near Optimum universal belief propagation based decoding of low density parity check codes, IEEE Trans. on Comm., 50(3), pages 406-414, 2002. Pour la variante « Self-corrected Min-Sum » on pourra se référer à l'article de V. Savin intitulé « Self-Corrected Min-Sum of LDPC codes », IEEE Int. Symp. on Information Theory (ISIT), Toronto, Canada, 2008.

Le décodage itératif se poursuit jusqu'à ce qu'un critère d'arrêt soit vérifié (contrôles de parité vérifiés, nombre maximum d'itérations atteint, valeurs absolues des LLRs franchissant une valeur de seuil, etc.)

A l'étape 660, on détermine enfin les valeurs binaires de chaque variable à partir de ses valeurs binaires étendues ainsi obtenues.

La Fig. 7 représente un exemple de graphe bipartite $\overline{G}$ associé à une représentation binaire étendue du code non binaire *C* et permettant un décodage selon la méthode de la Fig. 6.

L'exemple illustré est celui du code non binaire défini sur l'alphabet $A=\mathbf{F}_8$ par la matrice de parité **H** donnée en (1). On a ici $q$=8 et $p$=3, $N$=6 et $M$=3. Les variables sont notées $X_1,X_2,\ldots,X_6$ et les contraintes sont notés $Y_1,Y_2,Y_3$. Chaque variable est un élément de $\mathbf{F}_8$.

Chaque variable $X_n$ est représentée par son image binaire, à savoir trois valeurs binaires $(x_{n,0},x_{n,1},x_{n,2})$. Chaque contrainte $Y_m$ est représentée par son image binaire, à savoir trois contrôles de parité étendus $(y_{m,0},y_{m,1},y_{m,2})$.

Dans l'exemple illustré, la représentation des variables a été étendue au nombre maximal de bits, à savoir $q$-1=7 bits (autrement dit $\overline{p}$=7). De manière similaire, la représentation des contraintes a été étendue au nombre maximal de contrôles étendus. La représentation binaire étendue de la variable $X_n$ est ainsi notée $(a_{n,1},a_{n,2},\ldots,a_{n,7})$ et celle de $Y_m$ est notée $(b_{m,1},b_{m,2},\ldots,b_{m,7})$.

La représentation étendue est obtenue de la manière suivante :

- pour les variables $X_n$

$$\begin{aligned} a_{n,1} &= x_{n,0} \\ a_{n,2} &= x_{n,1} \\ a_{n,3} &= x_{n,0} + x_{n,1} \\ a_{n,4} &= x_{n,2} \\ a_{n,5} &= x_{n,0} + x_{n,2} \\ a_{n,6} &= x_{n,1} + x_{n,2} \\ a_{n,7} &= x_{n,0} + x_{n,1} + x_{n,2} \end{aligned} \qquad (36)$$

  On voit ainsi que chaque bit de la représentation binaire étendue d'une variable s'exprime comme une combinaison de ses valeurs binaires.
- pour les contraintes $Y_m$

$$\begin{aligned} b_{m,1} &= y_{m,0} \\ b_{m,2} &= y_{m,1} \\ b_{m,3} &= y_{m,0} + y_{m,1} \\ b_{m,4} &= y_{m,2} \\ b_{m,5} &= y_{m,0} + y_{m,2} \\ b_{m,6} &= y_{m,1} + y_{m,2} \\ b_{m,7} &= y_{m,0} + y_{m,1} + y_{m,2} \end{aligned} \quad (37)$$

On voit ainsi que chaque contrôle de parité étendu, s'exprime comme une combinaison linéaire de contrôles de parité de l'image binaire de cette contrainte.

La matrice $\overline{\mathbf{H}}_{bin}$, dont les lignes correspondent aux contrôles de parité étendus $b_{j,m}$ est de taille $M(q\text{-}1)\times N(q\text{-}1)$ c'est-à-dire $21\times42$. Cette matrice est donnée en Fig. 5.

Sur le graphe de la Fig. 7, on a représenté les variables par des hexagones, les valeurs binaires étendues des variables par des cercles, et les contrôles de parité étendus par des carrés.

Seule la partie du graphe correspondant au contrôle $Y_1$ a été représentée pour ne pas surcharger la figure. Bien entendu, les contrôles binaires étendus représentant les contraintes $Y_2$ et $Y_3$ sont également reliées aux valeurs binaires étendues des noeuds de variables, mais les arêtes correspondantes n'ont pas été représentées.

On a représenté en grisé les valeurs initiales des variables servant à initialiser le décodage. Plus précisément, les valeurs binaires $x_{n,0},x_{n,1},x_{n,2}$ servent à initialiser respectivement les valeurs binaires étendues $a_{n,1},a_{n,2},a_{n,4}$. Les autres valeurs binaires étendues peuvent être considérées comme des effacements, c'est-à-dire comme des inconnues (par exemple valeur de probabilité égale à 0,5 ou valeur de LLR égale à 0). Selon une variante, les autres valeurs binaires étendues sont également initialisées au moyen de l'équation (36) ci-dessus.

Après le décodage itératif à passages de messages, on obtient les valeurs binaires décodées des variables $X_1,X_2,...,X_6$ à partir de :

$$x_{n,i} = a_{n,2^i} \quad (38)$$

autrement dit, on vient simplement récupérer les valeurs binaires à partir des valeurs binaires étendues, de façon symétrique à l'étape d'initialisation.

On comprendra que la représentation binaire étendue des variables ne comprend pas nécessairement toutes les $\mathbf{F}_2$-combinaisons linéaires des valeurs binaires de ces variables. De même, la représentation binaire étendue des contraintes ne comprend pas nécessairement toutes les $\mathbf{F}_2$-combinaisons linéaires des contrôles de parité associés à ces contraintes.

Dans tous les cas, le fait d'utiliser une représentation étendue sur $\overline{p}>p$ valeurs binaires pour les variables et/ou $\overline{p}'>p$ équations de parité permet d'obtenir une matrice de densité moins dense et un graphe bipartite présentant un plus faible nombre de cycles. On notera que, de manière générale, le nombre $\overline{p}'$ d'équations de parité de la matrice $\overline{\mathbf{H}}_{bin}$ peut être différent de $\overline{p}$.

Dans le mode de réalisation décrit précédemment, les noeuds de variables 710 (symboles non-binaires) et 720 (valeurs binaires étendues) n'échangent des messages que lors de la phase d'initialisation et lors de la phase de récupération des valeurs décodées, au terme du décodage itératif.

On peut avantageusement exploiter le fait que les valeurs binaires étendues $a_{n,1},a_{n,2},...,a_{n,q\text{-}1}$ forment un mot de code de $S_p$, ou d'un mot de code raccourci lorsque le nombre de valeurs binaires étendues vérifie $\overline{p}<q\text{-}1$ (dans ce cas là seules $\overline{p}$ valeurs $a_{n,i}$ de $a_{n,1}a_{n,2},...,a_{n,q\text{-}1}$ sont prises en compte).

Selon une première variante du premier mode de réalisation, on s'assure périodiquement ou bien sur réalisation d'un critère, que les valeurs binaires étendues vérifient bien les contraintes du code (par exemple $a_{n,1}+a_{n,2}=a_{n,3}$). Si ce n'est pas le cas, on peut rechercher le mot de code $\hat{a}_{n,1}\hat{a}_{n,2},...,\hat{a}_{n,q\text{-}1}$ de $S_p$ le plus proche de $a_{n,1},a_{n,2},...,a_{n,q\text{-}1}$ au sens d'une certaine métrique (par exemple une métrique de Hamming) ou de manière équivalente au sens des probabilités, ce qui revient à décoder le mot de code au sens du critère de maximum de vraisemblance ou ML (*Maximum Likelihood*). On remplace alors le mot $a_{n,1},a_{n,2},...,a_{n,q\text{-}1}$ par $\hat{a}_{n,1},\hat{a}_{n,2},...,\hat{a}_{n,q\text{-}1}$ et l'on poursuit le décodage itératif. Cette variante trouve également à s'appliquer lorsque l'on considère un code $S_p$ raccourci, les contraintes portant alors sur sous ensemble de $\overline{p}$ des valeurs binaire étendues $a_{n,1},a_{n,2},...,a_{n,q\text{-}1}$.

Selon une seconde variante, on exploite le fait que les contraintes portant sur les variables binaires étendues ($a_{n,1}$,$a_{n,2}$,...,$a_{n,q-1}$ devant être un mot du code de $S_p$) portent également sur les messages, c'est-à-dire les informations extrinsèques que ces valeurs binaires transmettent aux noeuds de contrôle. On détermine alors des messages corrigés au sens du critère ML pour respecter ces contraintes, et ces messages corrigés sont utilisés en lieu et place des messages précités pour l'étape suivante de décodage itératif. Il s'agit ici d'une correction a *posteriori.* La conclusion vaut encore lorsque l'on considère un code raccourci.

Selon une troisième variante, on exploite le fait que les contraintes portant sur les variables binaires étendues ($a_{n,1}$,$a_{n,2}$,...,$a_{n,q-1}$ devant être un mot du code $S_p$) portent également sur les messages reçus par ces dernières, autrement dit les informations intrinsèques qui leur sont transmises par les noeuds de contrôle. Les messages reçus alors corrigés comme précédemment au sens du critère ML pour respecter ces contraintes et servent ensuite à déterminer les messages à retransmettre aux noeuds de contrôle. La conclusion vaut encore lorsque l'on considère un code raccourci

Dans tous ces variantes, on comprend que les noeuds de variables (représentés par des hexagones) puissent alors être interprétés comme des contraintes supplémentaires (vérification du code $S_p$ raccourci ou non).

La Fig. 8 représente un autre exemple de graphe bipartite du même code non binaire.

On a désigné par 810 les noeuds associés aux valeurs binaires de chaque variable. Les références 820 et 840 sont respectivement identiques aux références 720 et 740 de la Fig. 7.

On a désigné par 815 le graphe reliant les valeurs binaires et les valeurs binaires étendues des variables. Ce graphe représente les $\overline{p}$ combinaisons linéaires permettant de passer des premières aux secondes. Le graphe 815 sera dénommé dans la suite graphe auxiliaire du graphe étendu 800.

L'étape de décodage itératif comprend au moins une première phase de passage de messages entre les valeurs binaires et les valeurs binaires étendues des variables, à travers le graphe auxiliaire 815, et une seconde phase de passage de messages entre les valeurs binaires étendues des variables et les contrôles étendus, à travers le graphe 800.

On a ainsi un cycle de passage de messages à trois niveaux (810 -> 820 -> 840 -> 820 -> 810).

D'autres stratégies de passages de messages peuvent être envisagées par l'homme du métier sans sortir du cadre de la présente invention.

## Revendications

1. Méthode de décodage d'un code non binaire, en particulier d'un code LDPC non binaire, susceptible d'une représentation par graphe bipartite avec *N* noeuds de variables et *M* noeuds de contraintes, les variables prenant leurs valeurs dans un alphabet $A=\mathbf{F}_q$ non binaire, où $\mathbf{F}_q$ est un corps à *q* éléments, et étant linéairement contraintes au moyen d'une matrice de contraintes (H) à éléments dans $\mathbf{F}_q$, chaque variable étant représentée par une image binaire constituée d'une pluralité *p* de valeurs binaires, **caractérisée en ce que** :

   - on génère (620) pour chaque variable une pluralité $\overline{p}$ de valeurs binaires, dites valeurs binaires étendues, obtenues par $\overline{p}$ combinaisons linéaires distinctes à coefficients dans $\mathbf{F}_2$ desdites *p* valeurs binaires, hormis la combinaison nulle avec $p<\overline{p}\leq q-1$;
   - on calcule (630) une matrice de parité, dite matrice de parité étendue ($\overline{\mathbf{H}}_{bin}$), représentant des contrôles de parité sur les valeurs binaires étendues des variables, dits contrôles de parité étendus, lesdits contrôles de parité étendus étant induits par les contraintes sur lesdites variables, ladite matrice de parité étendue étant obtenue à partir d'une matrice binaire ($\mathbf{H}_{bin}$) représentant les contraintes desdites variables où chaque variable est exprimée par son image binaire;
   - on effectue (650) un décodage itératif à passage de messages à l'aide d'un second graphe bipartite (700,800), dit graphe étendu, représentant la matrice de parité étendue et reliant les contrôles de parité étendus aux valeurs binaires étendues des variables ;
   - on détermine (660) les valeurs binaires de chaque variable à partir de ses valeurs binaires étendues, obtenues au terme du décodage itératif.

2. Méthode de décodage selon la revendication 1, **caractérisée en ce que** l'alphabet A est constitué de $q=2^p$ éléments et que $\overline{p}=q-1$.

3. Méthode de décodage selon la revendication 1 ou 2, **caractérisée en ce que** l'on complète (630) ladite matrice de parité étendue, $\overline{\mathbf{H}}_{bin}$, en ajoutant des lignes supplémentaires, lesdites lignes supplémentaires étant obtenues au moyen de combinaisons linéaires distinctes à coefficients dans $\mathbf{F}_2$ des lignes existantes, hormis la combinaison nulle, chaque ligne de la matrice ainsi complétée définissant un contrôle de parité étendu, le graphe étendu reliant alors l'ensemble des valeurs binaires étendues des variables à l'ensemble des contrôles de parité étendus de la matrice $\overline{\mathbf{H}}_{bin}$ ainsi complétée.

**4.** Méthode de décodage selon les revendications 2 et 3, **caractérisée en ce que** le nombre de lignes supplémentaires ajoutées est de $q$-$p$-1.

**5.** Méthode de décodage selon l'une des revendications précédentes, **caractérisée en ce qu'**au moins une partie des valeurs binaires étendues de chaque variable est initialisée à l'aide des valeurs binaires de celle-ci.

**6.** Méthode de décodage selon l'une des revendications précédentes, **caractérisée en ce que**, pour au moins une itération du décodage itératif, les valeurs binaires étendues de chaque variable sont soumises à un décodage à maximum de vraisemblance pour obtenir des valeurs binaires étendues estimées vérifiant un ensemble de contraintes induites par lesdites $\overline{p}$ combinaisons linéaires, et que l'on remplace, pour chaque variable, lesdites valeurs binaires étendues par lesdites valeurs binaires étendues estimées pour poursuivre le décodage itératif.

**7.** Méthode de décodage selon l'une des revendications 1 à 5, **caractérisée en ce que**, pour au moins une itération du décodage itératif, les messages transmis par les valeurs binaires étendues de chaque variable sont corrigés au sens du maximum de vraisemblance pour vérifier un ensemble de contraintes induites par lesdites $\overline{p}$ combinaisons linéaires, et que l'on remplace, pour chaque variable, lesdits messages transmis au moyen des dits messages corrigés pour poursuivre le décodage itératif.

**8.** Méthode de décodage selon l'une des revendications 1 à 5, **caractérisée en ce que**, pour au moins une itération du décodage itératif, les messages reçus par les valeurs binaires étendues de chaque variable sont corrigés au sens du maximum de vraisemblance pour vérifier un ensemble de contraintes induites par lesdites $\overline{p}$ combinaisons linéaires, et que l'on remplace, pour chaque variable, lesdits messages reçus au moyens des dits messages corrigés pour poursuivre le décodage itératif.

**9.** Méthode de décodage selon les revendications précédentes, **caractérisée en ce qu'**elle utilise en outre un graphe auxiliaire (815) reliant les valeurs binaires aux valeurs binaires étendues des variables, ledit graphe auxiliaire représentant les combinaisons linéaires permettant de générer les secondes à partir des premières.

**10.** Méthode de décodage selon la revendication 9, **caractérisée en ce que** l'étape de décodage itératif comprend au moins une première phase de passage de messages entre les valeurs binaires et les valeurs binaires étendues des variables, à travers ledit graphe auxiliaire (815), et une seconde phase de passage de messages entre les valeurs binaires des variables et les contrôles de parité étendus, à travers ledit graphe étendu (800).

## Patentansprüche

**1.** Verfahren zum Decodieren eines nichtbinären Codes, insbesondere eines nichtbinären LDPC-Codes, der für eine bipartite Graph-Darstellung mit $N$ Variablen-Knoten und $M$ Constraint-Knoten geeignet ist, wobei die Variablen ihre Werte einem nichtbinären Alphabet $A=\mathbf{F}_q$ entnehmen, worin $\mathbf{F}_q$ ein Körper mit $q$ Elementen ist, und mittels einer Einschränkungsmatrix (H) mit Elementen in $\mathbf{F}_q$ linear beschränkt sind, wobei jede Variable durch ein binäres Bild dargestellt wird, das aus einer Mehrzahl $p$ von Binärwerten besteht,
**dadurch gekennzeichnet, dass**

- für jede Variable eine Vielzahl $\overline{p}$ von Binärwerten erzeugt wird (620), erweiterte Binärwerte genannt, die durch $\overline{p}$ unterschiedliche lineare Kombinationen mit Koeffizienten in $\mathbf{F}_2$ der Binärwerte $p$ erhalten werden, mit Ausnahme der Nullkombination mit $p<\overline{p}<q-1$;
- eine Paritätsmatrix, erweiterte Paritätsmatrix ($\overline{H}_{bin}$) genannt, berechnet wird (630), die Paritätsprüfungen der erweiterten Binärwerte der Variablen darstellt, erweiterte Paritätsprüfungen genannt, wobei die erweiterten Paritätsprüfungen durch die Einschränkungen der Variablen hervorgerufen werden, wobei die erweiterte Paritätsmatrix ausgehend von einer binären Matrix ($\mathbf{H}_{bin}$) erhalten wird, welche die Einschränkungen der Variablen darstellt, wobei jede Variable durch ihr Binärbild ausgedrückt wird;
- eine iterative Decodierung mit Nachrichtenaustausch mit Hilfe eines zweiten bipartiten Graphen (700, 800), erweiterter Graph genannt, erfolgt (650), der die erweiterte Paritätsmatrix darstellt und die erweiterten Paritätsprüfungen mit den erweiterten Binärwerten der Variablen verbindet;

- die Binärwerte jeder Variablen ausgehend von ihren erweiterten Binärwerten ermittelt werden (660), die am Ende der iterativen Decodierung erhalten werden.

2. Decodierverfahren nach Anspruch 1, **dadurch gekennzeichnet, dass** das Alphabet *A* aus $q=2^p$ Elementen besteht und dass $\overline{p}$ = q - 1 ist.

3. Decodierverfahren nach Anspruch 1 oder 2, **dadurch gekennzeichnet, dass** die erweiterte Paritätsmatrix $\overline{\mathbf{H}}_{bin}$ vervollständigt wird (630), indem zusätzliche Zeilen hinzugefügt werden, wobei die zusätzlichen Zeilen mittels verschiedener linearer Kombinationen mit Koeffizienten in $\mathbf{F}_2$ der existierenden Zeilen erhalten werden, mit Ausnahme der Nullkombination, wobei jede so vervollständigte Zeile der Matrix eine erweiterte Paritätsprüfung definiert, wobei der erweiterte Graph dann die gesamten erweiterten Binärwerten der Variablen mit den gesamten erweiterten Paritätsprüfungen der so vervollständigten Matrix $\overline{\boldsymbol{H}}_{bin}$ verbindet.

4. Decodierverfahren nach den Ansprüchen 2 und 3, **dadurch gekennzeichnet, dass** die Anzahl an zusätzlich hinzugefügten Zeilen *q* - *p* -1 ist.

5. Decodierverfahren nach einem der vorangehenden Ansprüche, **dadurch gekennzeichnet, dass** zumindest ein Teil der erweiterten Binärwerte einer jeden Variablen mit Hilfe von Binärwerten derselben initialisiert wird.

6. Decodierverfahren nach einem der vorangehenden Ansprüche, **dadurch gekennzeichnet, dass** für zumindest eine Iteration der iterativen Decodierung die erweiterten Binärwerte jeder Variablen einer Decodierung mit maximaler Wahrscheinlichkeit unterzogen, um geschätzte erweiterte Binärwerte zu erhalten, die einen durch die $\overline{p}$ linearen Kombinationen hervorgerufenen Satz von Einschränkungen erfüllen, und dass für jede Variable die erweiterten Binärwerte durch die geschätzten, erweiterten Binärwerte ersetzt werden, um die iterative Decodierung fortzusetzen.

7. Decodierverfahren nach einem der Ansprüche 1 bis 5, **dadurch gekennzeichnet, dass** für zumindest eine Iteration der iterativen Decodierung die Nachrichten, die über die erweiterten Binärwerte jeder Variablen übertragen werden, im Sinne einer maximalen Wahrscheinlichkeit korrigiert werden, um einen durch die $\overline{p}$ linearen Kombinationen hervorgerufenen Satz von Einschränkungen zu erfüllen, und dass für jede Variable die übertragenen Nachrichten unter Verwendung der korrigierten Nachrichten ersetzt werden, um die iterative Decodierung fortzusetzen.

8. Decodierverfahren nach einem der Ansprüche 1 bis 5, **dadurch gekennzeichnet, dass** für zumindest eine Iteration der iterativen Decodierung die Nachrichten, die über die erweiterten Binärwerte jeder Variablen empfangen werden, im Sinne einer maximalen Wahrscheinlichkeit korrigiert werden, um einen durch die $\overline{p}$ linearen Kombinationen hervorgerufenen Satz von Einschränkungen zu erfüllen, und dass für jede Variable die empfangenen Nachrichten unter Verwendung der korrigierten Nachrichten ersetzt werden, um die iterative Decodierung fortzusetzen.

9. Decodierverfahren nach einem der vorangehenden Ansprüche, **dadurch gekennzeichnet, dass** es ferner einen hilfsweisen Graphen (815) verwendet, welcher die Binärwerte mit den erweiterten Binärwerten der Variablen verbindet, wobei der Hilfsgraph die linearen Kombinationen darstellt, die gestatten, die zweiten ausgehend von den ersten zu erzeugen.

10. Decodierverfahren nach Anspruch 9, **dadurch gekennzeichnet, dass** der Schritt des iterativen Decodierens zumindest eine erste Phase des Nachrichtenaustauschs zwischen den Binärwerten und den erweiterten Binärwerten der Variablen durch den Hilfsgraphen (815) umfasst, sowie eine zweite Phase des Nachrichtenaustauschs zwischen den Binärwerten der Variablen und den erweiterten Paritätsprüfungen durch den erweiterten Graphen (800).

## Claims

1. A decoding method for non-binary codes, in particular for non-binary LDPC codes, amenable to representation by a bipartite graph with *N* variable vertices and *M* constraint vertices, the variables drawing their values from a non-binary alphabet $A = \mathbf{F}_q$ and being linearly constrained by means of a constraint matrix (**H**) having its elements in $\mathbf{F}_q$, each variable being represented by binary image comprised of a plurality *p* of binary values, **characterized in that**:

- a plurality $\overline{p}$ of binary values, called extended binary values, is generated (620) for each variable, obtained by $\overline{p}$ linear combinations with coefficients from $\mathbf{F}_2$ of said *p* binary values, excluding the zero combination, where

$p < \bar{p} \leq q$-1;

- a parity matrix ($\overline{\mathbf{H}}_{bin}$) is calculated (630), called the extended parity matrix, representing parity checks on the extended binary values of the variables, called extended parity checks, said extended parity checks being induced by the constraints on said variables, said extended parity matrix being obtained from a binary matrix ($\mathbf{H}_{bin}$) representing the constraints on said variables, where each variable is represented by its binary image;
- an iterative message-passing decoding process (650) is carried out with the use of a second bipartite graph (700, 800), called an extended graph, representing the extended parity matrix and connecting the extended parity checks with the extended binary values of the variables;
- the binary values of each variable are determined (660) from its extended binary values, obtained at the conclusion of the iterative decoding process.

**2.** A decoding method according to claim 1, **characterized in that** alphabet *A* is made up of elements and $\bar{p} = q - 1$.

**3.** A decoding method according to claim 1 or 2, **characterized in that** said parity matrix, $\overline{\mathbf{H}}_{bin}$, is completed (630) by adding additional rows, said additional rows being obtained by means of distinct linear combinations, with coefficients from $\mathbf{F}_2$, of existing rows, excluding the zero combination, each row of the matrix thus completed defining an extended parity check, the extended graph then connecting the set of extended binary values of the variables with the set of extended parity checks of matrix $\overline{\mathbf{H}}_{bin}$ thus completed.

**4.** A decoding method according to claims 2 and 3, **characterized in that** the number of additional rows added in is equal to *q-p-1.*

**5.** A decoding method according to one of the foregoing claims, **characterized in that** at least part of the extended binary values of each variable is initialized using its own binary values.

**6.** A decoding method according to one of the foregoing claims **characterized in that**, for at least one iteration of the iterative decoding process, the extended binary values of each variable are subjected to a maximum-likelihood decoding to obtain estimated extended binary values confirming a set of constraints induced by said $\bar{p}$ linear combinations, said extended binary values being replaced, for each variable, by said estimated extended binary values for the purpose of continuing the iterative decoding process.

**7.** A decoding method according to one of claims 1 through 5 **characterized in that**, for at least one iteration of the iterative decoding process, the messages passed by the extended binary values of each variable are corrected in the maximum-likelihood sense to confirm a set of constraints induced by said $\bar{p}$ linear combinations, and said passed messages are replaced, for each variable, with said corrected messages for the purpose of continuing the iterative decoding process.

**8.** A decoding method according to one of claims 1 through 5 **characterized in that**, for at least one iteration of the iterative decoding process, the messages received by the extended binary values of each variable are corrected in the maximum-likelihood sense to confirm a set of constraints induced by said $\bar{p}$ linear combinations, and said received messages are replaced, for each variable, by said corrected messages for the purpose of continuing the iterative decoding process.

**9.** A decoding method according to the foregoing claims, **characterized in that** it uses in addition an auxiliary graph (815) connecting the binary values to the extended binary values of the variables, said auxiliary graph representing the linear combinations that allow the latter to be generated from the former.

**10.** A decoding method according to Claim 9, **characterized in that** the iterative decoding step includes at least a first phase of message passing between the binary values and the extended binary values of the variables, through said auxiliary graph (815), and a second phase of message-passing between the binary values of the variables and the extended parity checks, through said extended graph (800).

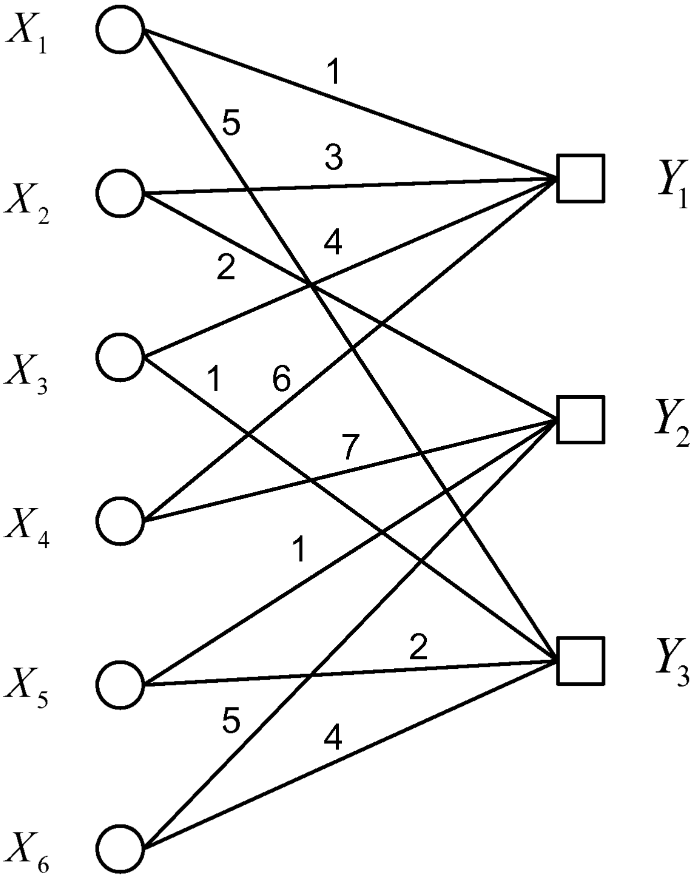


**Fig. 1**

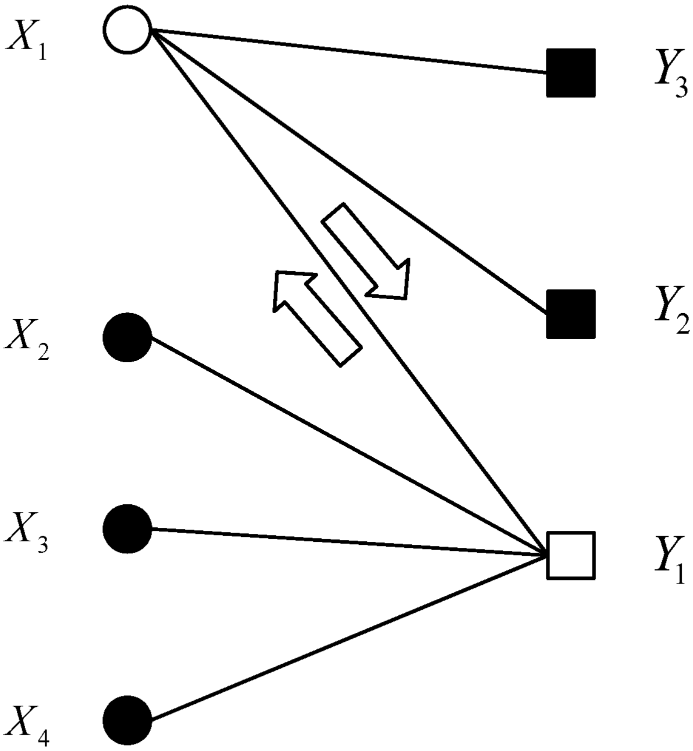


**Fig. 2**

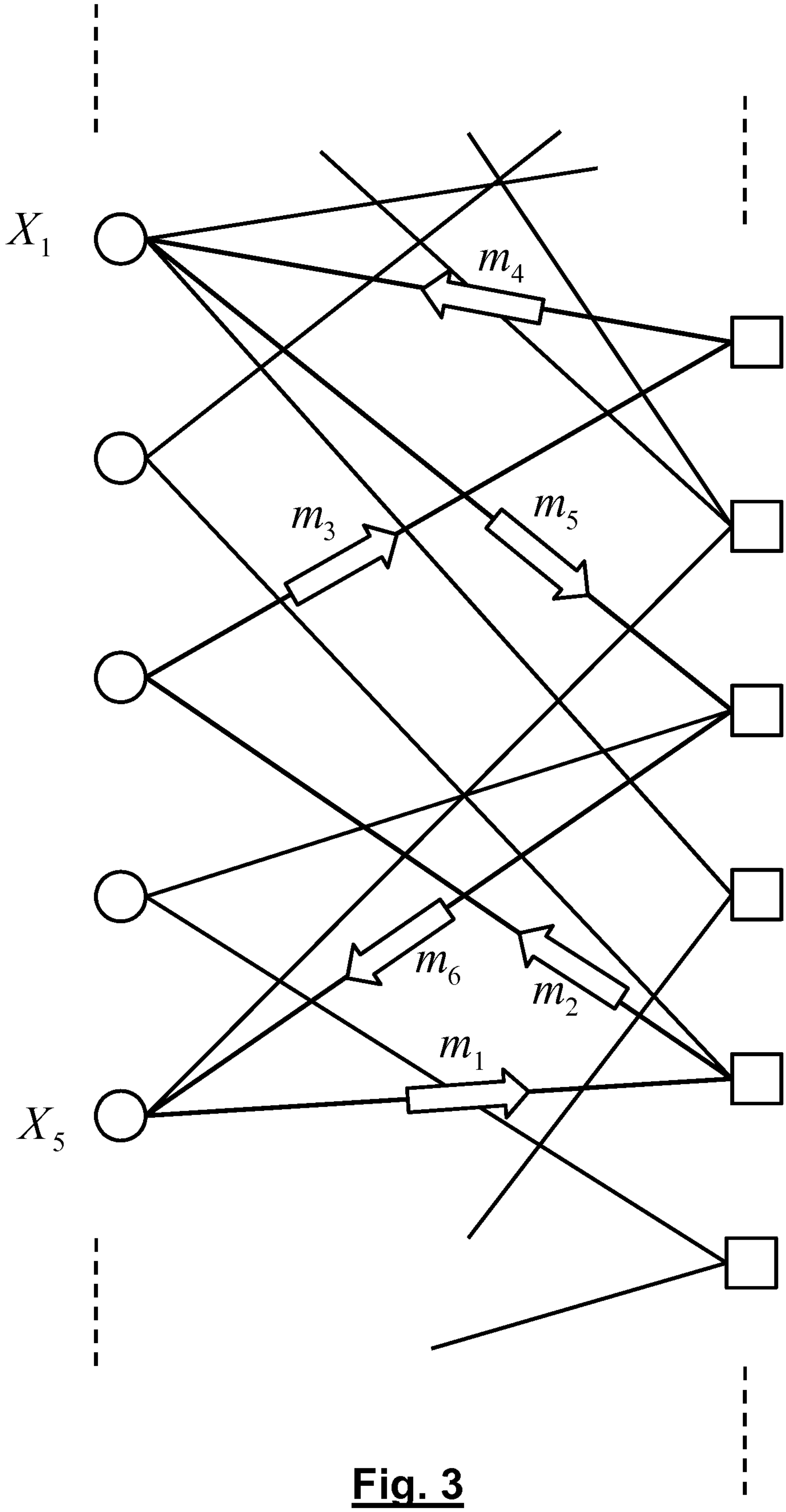


Fig. 3

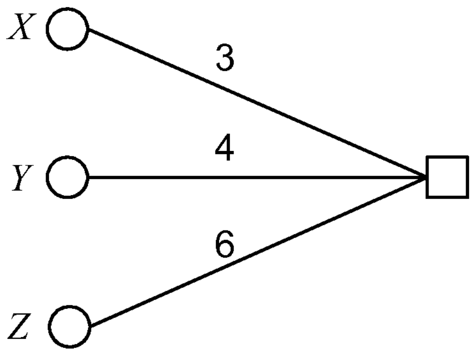


$$\mathbf{H} = \begin{pmatrix} 3 & 4 & 6 \end{pmatrix}$$

**Fig. 4A**

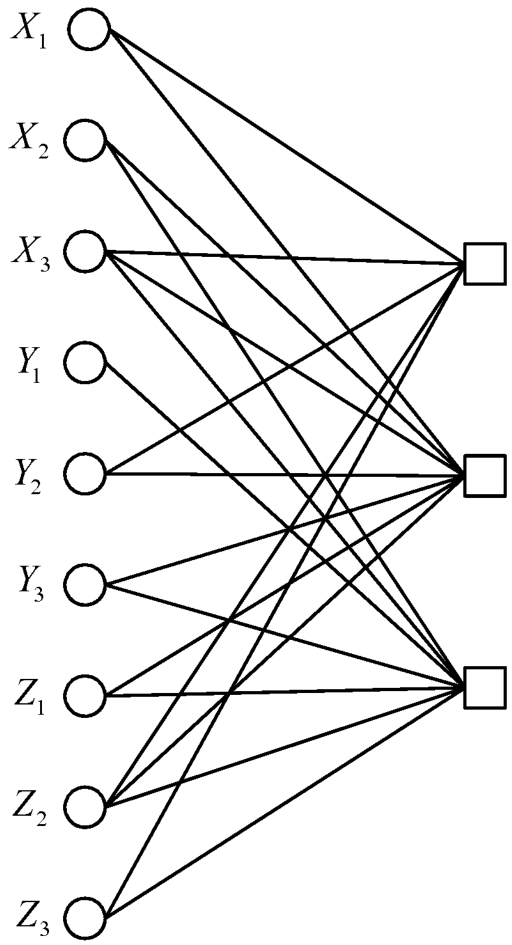


$$\mathbf{H}_{\mathbf{bin}} = \begin{pmatrix} 1 & 0 & 1 & 0 & 1 & 0 & 0 & 1 & 1 \\ 1 & 1 & 1 & 0 & 1 & 1 & 1 & 1 & 0 \\ 0 & 1 & 1 & 1 & 0 & 1 & 1 & 1 & 1 \end{pmatrix}$$

**Fig. 4B**

$$\mathbf{H} = \begin{pmatrix} 1 & 3 & 4 & 6 & 0 & 0 \\ 0 & 2 & 0 & 7 & 1 & 5 \\ 5 & 0 & 1 & 0 & 2 & 4 \end{pmatrix}$$

$$\mathbf{H_{bin}} = \left(\begin{array}{ccc|ccc|ccc|ccc|ccc|ccc}
1&0&0&1&0&1&0&1&0&0&1&1&0&0&0&0&0&0 \\
0&1&0&1&1&1&0&1&1&1&1&0&0&0&0&0&0&0 \\
0&0&1&0&1&1&1&0&1&1&1&1&0&0&0&0&0&0 \\
\hline
0&0&0&0&0&1&0&0&0&1&1&1&1&0&0&1&1&0 \\
0&0&0&1&0&1&0&0&0&1&0&0&0&1&0&0&0&1 \\
0&0&0&0&1&0&0&0&0&1&1&0&0&0&1&1&0&0 \\
\hline
1&1&0&0&0&0&1&0&0&0&0&0&0&0&1&0&1&0 \\
0&0&1&0&0&0&0&1&0&0&0&0&1&0&1&0&1&1 \\
1&0&0&0&0&0&0&0&1&0&0&0&0&1&0&1&0&1
\end{array}\right)$$

$$\overline{H}_{\text{bin}} = \left(\begin{array}{ccccccc|ccccccc|ccccccc|ccccccc|ccccccc|ccccccc}
1&&&&&& & &&&&&& & &1&&&&&1 & &&&&&1& & &&&&&& & &&&&&& \\
&1&&&&& & &&&&&&1 & &&&&&1& & &&&&1&& & &&&&&& & &&&&&& \\
&&1&&&& & &1&&&&& & &&&1&&& & &&1&&&& & &&&&&& & &&&&&& \\
&&&1&&& & &&&&&1& & &&&&1&& & &&&&&&1 & &&&&&& & &&&&&& \\
&&&&&& & &&1&&&& & &1&&&&&1 & 1&&&&&& & &&&&&& & &&&&&& \\
&&&&&& & 1&&&1&&& & &&1&&&& & &1&&&&& & &&&&&& & &&&&&& \\
&&&&&& & &&&&&& & 1&&&&&1& & &&&1&1&& & &&&&&& & &&&&&& \\
\hline
&&&&&& & &&&1&&& & &&&&&& & &&&&&& & 1&&1&&&& & &&1&&&& \\
&&&&&& & &&&&1&& & &&&&&& & 1&&&&&& & &1&&&&& & &&&1&&& \\
&&&&&& & 1&&&&&& & &&&&&& & &&&&&& & &&1&&&& & 1&&&&&&1 \\
&&&&&& & &1&&&&& & &&&&&& & &&1&&&& & &&&&&& & 1&&&&&1& \\
&&&&&& & &&&&&1& & &&&&&& & &&&1&&& & &&&&&& & &1&&&&&1 \\
&&&&&& & &&&&&&1 & &&&&&& & &1&&&&& & &&&&&1& & &&&&1&& \\
&&&&&& & &&1&&&& & &&&&&& & &&&&1&& & &&&&&&1 & &&&&&1& \\
\hline
&&1&&&& & &&&&&& & 1&&&&&& & &&&&&& & &&&&&& & &1&&&&&1 \\
&&&1&&& & &&&&&& & &1&&&&& & &&&&&& & &&&&1&& & &&&&&1& \\
&&&&&&1 & &&&&&& & &&1&&&& & &&&&&& & 1&&&&&& & &&&1&&& \\
1&&&&&& & &&&&&& & &&&1&&& & &&&&&& & &1&&&&& & &&&&1&& \\
&1&&&&& & &&&&&& & &&&&1&& & &&&&&& & &&&&&1& & &&&&&&1 \\
&&&&1&& & &&&&&& & &&&&&1& & &&&&&& & &&&&&& & &&1&&&&1 \\
&&&&&1& & &&&&&& & &&&&&&1 & &&&&&& & &&&&&& & 1&&&&&&1
\end{array}\right)$$

**Fig. 5**

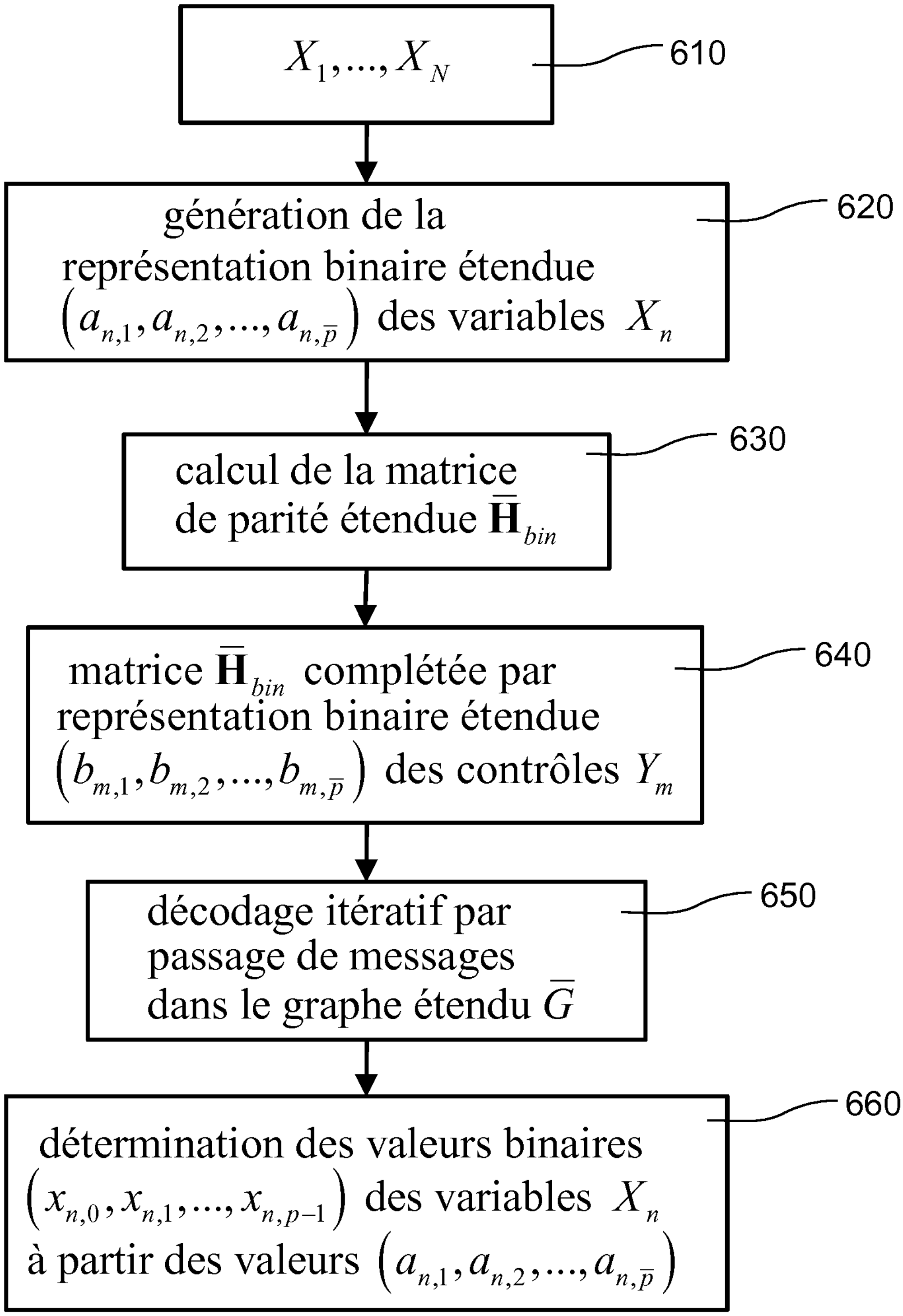
$X_1, \ldots, X_N$
610
génération de la représentation binaire étendue $(a_{n,1}, a_{n,2}, \ldots, a_{n,\bar{p}})$ des variables $X_n$
620
calcul de la matrice de parité étendue $\bar{\mathbf{H}}_{bin}$
630
matrice $\bar{\mathbf{H}}_{bin}$ complétée par représentation binaire étendue $(b_{m,1}, b_{m,2}, \ldots, b_{m,\bar{p}})$ des contrôles $Y_m$
640
décodage itératif par passage de messages dans le graphe étendu $\bar{G}$
650
détermination des valeurs binaires $(x_{n,0}, x_{n,1}, \ldots, x_{n,p-1})$ des variables $X_n$ à partir des valeurs $(a_{n,1}, a_{n,2}, \ldots, a_{n,\bar{p}})$
660

**Fig. 6**

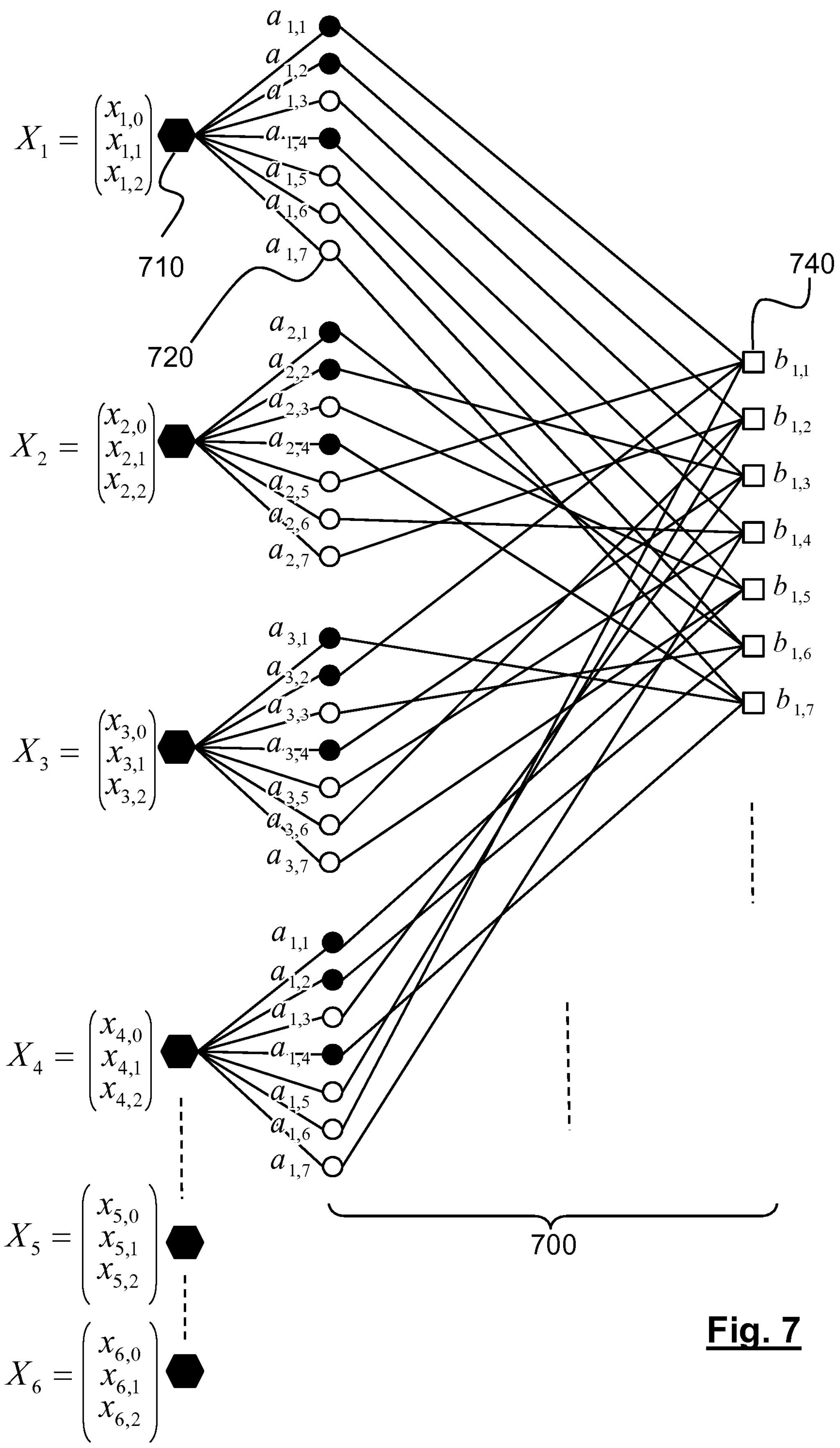
$X_1 = \begin{pmatrix} x_{1,0} \\ x_{1,1} \\ x_{1,2} \end{pmatrix}$
$X_2 = \begin{pmatrix} x_{2,0} \\ x_{2,1} \\ x_{2,2} \end{pmatrix}$
$X_3 = \begin{pmatrix} x_{3,0} \\ x_{3,1} \\ x_{3,2} \end{pmatrix}$
$X_4 = \begin{pmatrix} x_{4,0} \\ x_{4,1} \\ x_{4,2} \end{pmatrix}$
$X_5 = \begin{pmatrix} x_{5,0} \\ x_{5,1} \\ x_{5,2} \end{pmatrix}$
$X_6 = \begin{pmatrix} x_{6,0} \\ x_{6,1} \\ x_{6,2} \end{pmatrix}$
$a_{1,1}$ $a_{1,2}$ $a_{1,3}$ $a_{1,4}$ $a_{1,5}$ $a_{1,6}$ $a_{1,7}$
$a_{2,1}$ $a_{2,2}$ $a_{2,3}$ $a_{2,4}$ $a_{2,5}$ $a_{2,6}$ $a_{2,7}$
$a_{3,1}$ $a_{3,2}$ $a_{3,3}$ $a_{3,4}$ $a_{3,5}$ $a_{3,6}$ $a_{3,7}$
$a_{1,1}$ $a_{1,2}$ $a_{1,3}$ $a_{1,4}$ $a_{1,5}$ $a_{1,6}$ $a_{1,7}$
$b_{1,1}$ $b_{1,2}$ $b_{1,3}$ $b_{1,4}$ $b_{1,5}$ $b_{1,6}$ $b_{1,7}$
710
720
740
700

Fig. 7

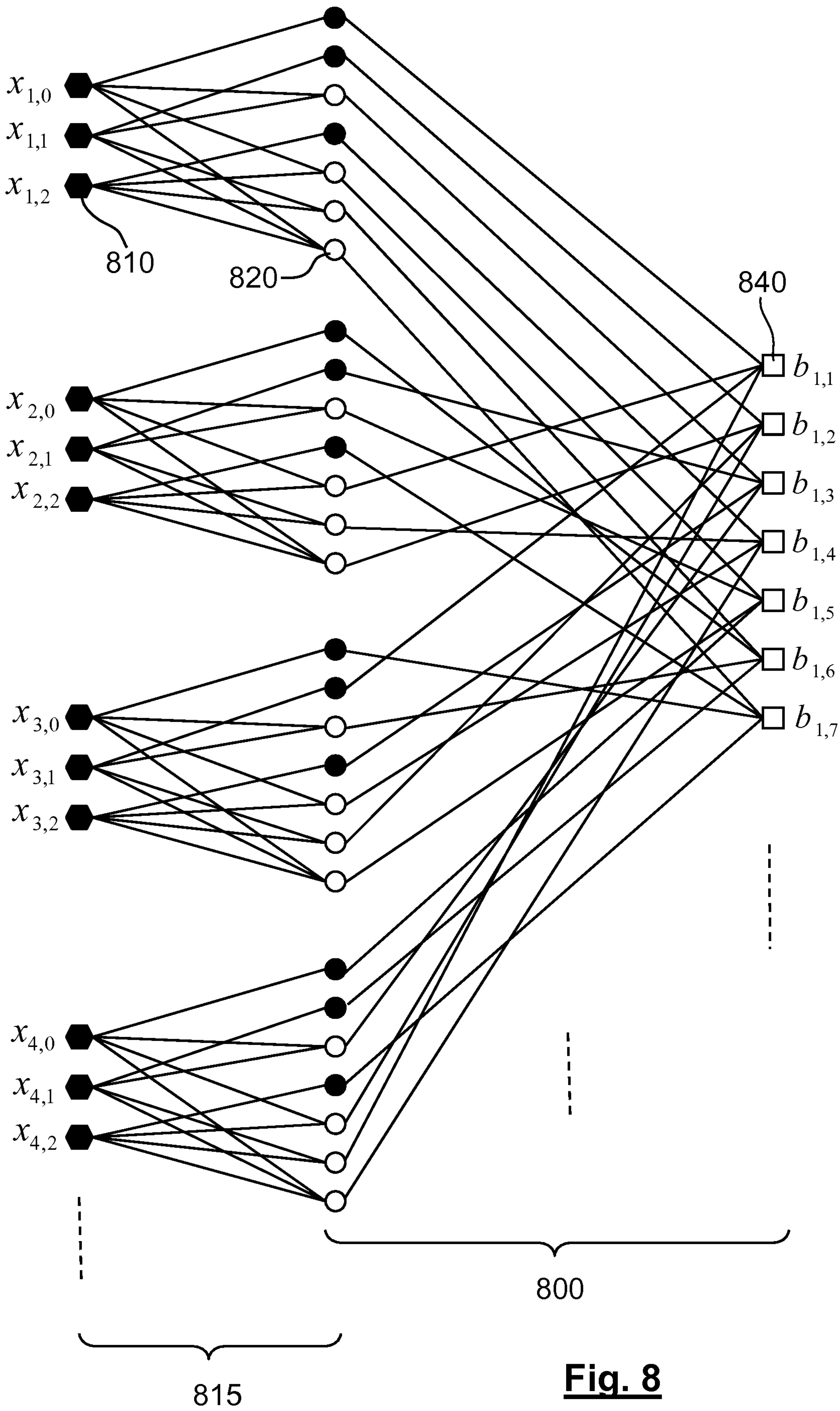
$x_{1,0}$
$x_{1,1}$
$x_{1,2}$
810
820
840
$b_{1,1}$
$b_{1,2}$
$b_{1,3}$
$b_{1,4}$
$b_{1,5}$
$b_{1,6}$
$b_{1,7}$
$x_{2,0}$
$x_{2,1}$
$x_{2,2}$
$x_{3,0}$
$x_{3,1}$
$x_{3,2}$
$x_{4,0}$
$x_{4,1}$
$x_{4,2}$
800
815

Fig. 8

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- GB 2455274 A


### Littérature non-brevet citée dans la description


- Low density parity check codes. **R. GALLAGER.** IEEE Trans. Inform. Theory. 1962, vol. IT-8, 21-28
- **C. BERROU et al.** Near optimum error correcting coding and decoding : turbocodes. *IEEE Trans. Inform. Theory,* 1996, vol. 44 (10), 1261-1271
- Min-Max decoding for non binary LDPC codes. **V. SAVIN.** IEEE Int. Symp. on Information Theory (ISIT). 2008
- **J. CHEN et al.** Near Optimum universal belief propagation based decoding of low density parity check codes. *IEEE Trans. on Comm.,* 2002, vol. 50 (3), 406-414
- Self-Corrected Min-Sum of LDPC codes. **V. SAVIN.** IEEE Int. Symp. on Information Theory (ISIT). 2008